# DEMANDE DE BREVET EUROPEEN

(11) **EP 1 550 894 A1**
(43) Date de publication de la demande: **06.07.2005**
(21) Numéro de dépôt: 04107000.4
(22) Date de dépôt: 27.12.2004
(51) Int. Cl.: G02B 26/08

(54) **Dispositif optique avec un élément optique mobile apte à interagir avec une structure optique de guidage**

(30) Priorité: 29.12.2003 FR 0351220
(71) Demandeur: COMMISSARIAT A L'ENERGIE ATOMIQUE, 75752 Paris Cédex 15 (FR)
(72) Inventeur: OLLIER, Eric, 38100, GRENOBLE (FR)
(74) Mandataire: Poulin, Gérard

(57) **Abrégé**

Il s'agit d'un dispositif optique comportant une structure optique de guidage (10) d'au moins un faisceau optique (11), un élément optique mobile (20) destiné à interagir ou non avec le faisceau optique grâce à des moyens de déplacement (40) de l'élément optique, un support flexible (21) reliant l'élément optique à la structure optique de guidage. Le dispositif comporte un dispositif de positionnement (30) de l'élément optique par rapport à la structure optique de guidage comportant une première référence mécanique (30.1) liée à la structure optique de guidage et une seconde référence mécanique (30.2) liée à l'élément optique mobile, des moyens (30.3) pour mettre en relation la seconde et la premières références mécaniques, cette mise en relation autorisant un mouvement de l'élément optique selon au moins un plan contenant au moins les première et seconde références mécaniques (30.1, 30.2) ainsi que la structure optique de guidage (10).

Application notamment dans les communications optiques.

## Description

### DOMAINE TECHNIQUE

La présente invention est relative à un dispositif optique avec un élément optique mobile apte à interagir avec une structure optique de guidage. Un tel dispositif trouve par exemple son application dans le domaine des télécommunications optiques et sert à réaliser notamment des fonctions de commutation de signaux optiques par exemple dans des brasseurs optiques capables de mettre sélectivement en communication une ou plusieurs voies optiques d'entrée avec une ou plusieurs voies optiques de sortie.

Les télécommunications optiques se développent à un rythme très soutenu pour faire face à l'augmentation du trafic de données et à l'intérêt croissant pour Internet. Les capacités des réseaux optiques se sont considérablement accrues grâce à l'introduction des systèmes de multiplexage en longueur d'onde dense. Il apparaît un besoin incontournable de réaliser des fonctions de commutation en tout optique, c'est à dire sans la réaliser de manière électrique après avoir démodulé le signal optique.

### ÉTAT DE LA TECHNIQUE ANTÉRIEURE

Le texte qui suit fait référence à des documents numérotés [1] à [14] dont les références complètes se trouvent en fin de description. Ces documents illustrent divers dispositifs de commutation optique connus.

On distingue, parmi les commutateurs optiques, essentiellement deux familles qui comprennent d'une part, les commutateurs entièrement intégrés et d'autre part, les commutateurs pourvus d'un organe mécanique mobile.

Les commutateurs optiques entièrement intégrés, présentent, par exemple, des structures dites DOS (Digital Optical Switches, commutateurs optiques numériques) ou MZI (Mach-Zehnder Interferometer, interféromètre de Mach-Zehnder). Ils utilisent les propriétés thermo-optiques ou électro-optiques de certains matériaux, et leur influence sur l'indice optique, pour réaliser la fonction de commutation. Les commutateurs de ce type ont certes l'avantage de pouvoir être facilement intégrés dans un circuit optique, mais souffrent de limitations dues à leur sensibilité à la longueur d'onde ou à la polarisation de la lumière à commuter. Une autre limitation est leur consommation en énergie élevée dans le cas notamment de l'actionneur thermo-optique. Enfin, les commutateurs utilisant l'effet thermo-optique souffrent de plus d'un temps de réponse médiocre, et sont donc lents.

Les commutateurs à organe mécanique sont ainsi privilégiés dans les applications où une bonne insensibilité à la polarisation et à la longueur d'onde de la lumière à commuter est requise. On peut distinguer différents types de ces commutateurs généralement en fonction de l'organe mécanique impliqué dans la commutation.

Le document [1] montre un commutateur basé sur le mouvement d'une fibre optique. Un tel commutateur présente une très faible diaphotie, c'est-à-dire un très faible couplage parasite entre les voies de commutation adjacentes. En revanche, sa fabrication se heurte à des difficultés liées aux exigences d'alignement très précises entre les fibres. Son utilisation reste limitée principalement à des composants de petite taille. Le document [2] montre également un commutateur avec un guide optique. Celui-ci est mû par un actionneur intégré sur la même puce. Ces commutateurs peuvent présenter un nombre plus important de voies de commutation tout en conservant l'avantage d'un faible couplage parasite entre voies (diaphotie).

Les documents [3], [4] et [5] proposent d'utiliser des micro-miroirs susceptibles d'être interposés dans des faisceaux de lumière. Les commutateurs à micro-miroirs utilisent un espace unique de libre propagation de faisceaux lumineux. Dans cet espace, à deux ou trois dimensions, il est possible de déplacer des miroirs qui viennent s'interposer dans les faisceaux lumineux pour en modifier la trajectoire. Une des principales limitations rencontrées avec ce type de commutateurs optiques tient à la divergence des faisceaux dans l'espace de commutation en espace libre. Cela limite aussi la taille des matrices regroupant plusieurs commutateurs et entraîne de sérieuses difficultés de mise en oeuvre (et donc de coûts) de la connexion avec les fibres optiques. On a tendance à introduire des micro-lentilles pour élargir et collimater les faisceaux et l'alignement de ces différents composants est très délicat.

Dans les configurations décrites dans les documents [4], [6], [7], la lumière est guidée par des fibres optiques et un miroir vient s'intercaler entre les extrémités de fibres optiques pour réaliser une fonction de commutation. Le miroir se déplace dans un plan qui est soit perpendiculaire au plan dans lequel se trouvent les fibres soit dans un plan qui parallèle au plan des fibres grâce à une commande électrostatique.

Un des intérêts de ces configurations est qu'elles préconisent un dispositif de positionnement des fibres optiques. Le document [4] utilise des languettes souples gravées dans le substrat autour des cavités accueillant les fibres optiques et les documents [6] et [7] les propriétés de gravure humide du silicium en fonction des plans cristallins. En revanche l'inconvénient de cette approche provient du montage manuel des fibres optiques sur un support collectif sur lequel sont réalisés collectivement des miroirs associés chacun à leur dispositif mécanique de déplacement. Cela induit un coût de fabrication supplémentaire et s'avère peu adapté à la réalisation de matrices.

Dans d'autres réalisations [8], [9], la lumière est guidée par des guides optiques, un miroir venant s'intercaler dans une cavité séparant deux extrémités de voies optiques guidées coplanaires.

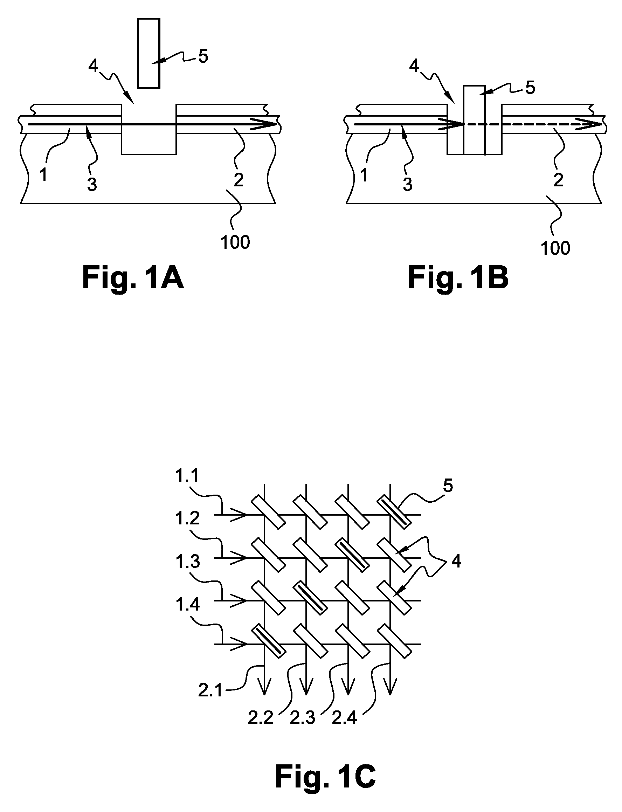

On peut se référer aux figures 1A, 1B qui montrent un tel commutateur élémentaire destiné à coopérer avec des voies optiques guidées 1, 2. La lumière 3 guidée par l'une des voies 1 doit se propager dans l'autre 2 ou être arrêtée pour être dirigée vers une autre voie optique (non représentée sur les figures 1A, 1B). La réorientation vers une autre voie est visible sur la figure 1C.

Les deux voies optiques guidées 1, 2 sont disposées au sein d'un substrat 100 et entre deux extrémités voisines des deux voies optiques guidées 1, 2 se trouve un logement 4 apte à accueillir un appendice optique 5. Lorsque l'appendice optique 5 n'est pas dans le logement 4, de la lumière 3 peut se propager d'une voie optique guidée 1 à l'autre 2 en traversant librement le logement 4 (figure 1A). Lorsque l'appendice optique 5 est placé dans le logement 4 de la lumière 3 guidée par l'une des voies 1 ou 2 ne peut plus se propager dans l'autre voie 2 ou 1 (figure 1B). Elle est arrêtée, soit réfléchie, soit atténuée selon la nature de l'appendice optique 5 qui peut être un obturateur, un miroir ou une lame semi-réfléchissante.

Sur la figure 1C, des voies optiques guidées 1.1, 1.2, 1.3, 1.4 d'entrée sont agencées en lignes et des voies optiques guidées 2.1, 2.2, 2.3, 2.4 de sortie sont agencées en colonnes. Les logements 4 sont à la croisée entre une ligne et une colonne. Des appendices optiques 5 sont placés dans certains des logements 4.

Dans ces réalisations, l'appendice optique est monté sur un support qui lui permet de se mouvoir dans un plan perpendiculaire au substrat ou parallèle au substrat pour interagir ou non avec la lumière. Ce support est fabriqué sur le même substrat que les guides optiques dans la même couche ou parfois en utilisant des couches supplémentaires. Dans d'autres cas, les voies optiques guidées et les logements sont fabriqués sur un substrat et l'appendice optique et son support sont fabriqués sur un autre substrat, les deux substrats étant ensuite assemblés l'un à l'autre.

Le document [10] décrit l'assemblage par la technique de puce retournée (connue sous la dénomination de flip-chip) d'une matrice de commutateurs 2x2 basés sur des miroirs en silicium se déplaçant dans le plan de la matrice avec une matrice de guides optiques.

Les brevets [11], [12] et [13] montrent l'assemblage de dispositifs mécaniques incluant un miroir et de circuits de guides optiques permettant d'insérer des miroirs dans des cavités séparant les guides optiques avec un déplacement s'effectuant perpendiculairement au substrat au sein duquel se trouve le circuit de guides optiques.

Le document [14] montre également l'assemblage par flip-chip d'une puce de type micro-miroir MEMS (abréviation anglo-saxonne de Micro-Electro-Mechanical System soit micro-système électromécanique) sur une puce guide optique avec cavité, le mouvement du micro-miroir étant perpendiculaire au plan des puces. Les solutions dans lesquelles le déplacement se fait dans un plan perpendiculaire au plan des substrats conduisent à des commutateurs beaucoup moins encombrants que si le déplacement se fait dans le plan du substrat. Ces commutateurs sont donc avantageux pour construire des matrices avec beaucoup de voies d'entrée et de voies de sortie.

Un inconvénient de ces dispositifs est que le positionnement relatif des miroirs avec les voies optiques guidées n'est pas satisfaisant, et ce à cause notamment du support du miroir et du déplacement qui ne se fait que dans un plan. En fait ce positionnement n'est pas traité de manière spécifique. La qualité de l'alignement est tributaire en général de la maîtrise de la fabrication. L'alignement en position latérale et en angle est déterminant dans l'obtention de faibles pertes optiques. Une précision de l'ordre du micromètre voire moins est recherchée et elle n'est pas atteinte avec la plupart des techniques de fabrication actuelles. C'est en particulier le cas dans les configurations où deux substrats doivent être assemblés. De plus, les solutions utilisées pour le positionnement des fibres optiques ne sont pas directement transposables.

### EXPOSÉ DE L'INVENTION

La présente invention a pour but de proposer un dispositif optique comportant une structure optique de guidage d'au moins un faisceau optique, un élément optique mobile destiné à interagir au non avec le faisceau optique guidé, ne présentant pas les limitations et difficultés ci-dessus.

Ce dispositif optique présente une précision de positionnement entre l'élément optique mobile et la structure optique de guidage bien meilleure que par le passé. Cette meilleure précision est acquise, que l'élément optique mobile et la structure optique de guidage soient réalisés sur un même substrat ou que la structure optique de guidage soit réalisée sur un premier substrat et que l'élément optique mobile soit réalisé sur un second substrat, les deux substrats étant ensuite assemblés même grossièrement.

Pour y parvenir, la présente invention prévoit un dispositif de positionnement entre l'élément optique mobile et la structure optique de guidage, ce dispositif comportant des références mécaniques liées d'une part à l'élément optique et d'autre part à la structure optique de guidage et des moyens pour mettre en relation les deux références mécaniques aptes à déplacer l'élément optique selon au moins un plan contenant les références mécaniques ainsi que la structure optique de guidage.

Plus précisément, la présente invention est un dispositif optique comportant une structure optique de guidage d'au moins un faisceau optique, un élément optique mobile destiné à interagir ou non avec le faisceau optique grâce à des moyens de déplacement de l'élément optique, un support flexible reliant l'élément optique à la structure optique de guidage, caractérisé en ce qu'il comporte un dispositif de positionnement de l'élément optique par rapport à la structure optique de guidage, comportant une première référence mécanique liée à la structure optique de guidage, une seconde référence mécanique liée à l'élément optique mobile, et des moyens pour mettre en relation la seconde référence mécanique et la première référence mécanique, cette mise en relation autorisant un mouvement de l'élément optique selon au moins un plan contenant la première et la seconde références mécaniques ainsi que la structure optique de guidage.

L'élément optique est alors apte à se mouvoir en translation et/ou en rotation. Ces mouvements peuvent se faire selon au moins une direction de l'espace.

Les moyens pour mettre en relation et les moyens de déplacement sont avantageusement distincts, cela permet d'arriver plus aisément à un positionnement précis de l'élément optique mobile par rapport à la structure optique de guidage, ce positionnement ne devant pas être remis en cause lors de déplacements de l'élément optique pour le mettre en interaction ou non avec un faisceau optique véhiculé par la structure optique de guidage.

Les moyens pour mettre en relation peuvent être passifs, la mise en relation intervenant une seule fois pour toute lors de la fabrication du dispositif optique. A titre d'exemple, cette relation passive peut être obtenue par le relâchement et la déformation d'une structure mécanique contrainte, cette déformation peut être en particulier un flambage.

Dans un autre mode de réalisation, les moyens pour mettre en relation sont actifs et sont activables avant et/ou pendant et/ou après le déplacement de l'élément optique mobile.

Les moyens pour mettre en relation peuvent comporter au moins un couple d'électrodes, dans le couple une des électrodes est mobile.

Lorsqu'il y a plusieurs couples d'électrodes, les électrodes de couples différents peuvent s'étendront dans des plans sensiblement perpendiculaires.

Selon un mode avantageux, la seconde référence mécanique est liée d'une manière flexible à l'élément optique mobile par une liaison flexible.

Cette liaison flexible aura de préférence une épaisseur inférieure à celle d'une électrode mobile des moyens pour mettre en relation.

De manière avantageuse au point de vue réalisation, le support flexible, la seconde référence mécanique, l'élément optique mobile et la liaison entre la seconde référence mécanique et l'élément optique peuvent former un bloc mobile.

Le bloc mobile peut porter ou former au moins une électrode mobile des moyens pour mettre en relation et une électrode mobile des moyens de déplacement.

L'élément optique mobile est apte à plonger dans ou à sortir d'une cavité lors de son déplacement, dans cette cavité débouche la structure optique de guidage.

La cavité peut contenir un fluide d'adaptation d'indice pour réduire des pertes d'insertion.

Les moyens de déplacement de l'élément optique peuvent comporter en sus d'une électrode mobile une électrode fixe solidaire d'un couvercle de protection de l'élément optique.

La première référence mécanique et la seconde référence mécanique peuvent être choisies parmi une ou plusieurs surfaces, une ou plusieurs pièces à arête ou à pointes ou une combinaison de ces éléments.

Dans un autre mode de réalisation, la première référence mécanique et la seconde référence mécanique peuvent être choisies parmi une ou plusieurs protubérances, un logement pour chaque protubérance ou une combinaison de ces éléments.

Le logement est, de préférence, équipé de moyens de guidage pour la protubérance. Cela permet de se passer d'un ou plusieurs couples d'électrodes des moyens de mise en relation.

Le logement peut être une rainure en V. Dans cette configuration, les moyens de guidage peuvent être les parois de la rainure en V.

Dans un autre mode de réalisation, les moyens de guidage peuvent être des languettes souples.

La structure optique de guidage comporte n voies optiques guidées d'un côté de l'élément optique mobile et m voies optiques de l'autre côté de l'élément optique mobile, n et m étant des entiers, au moins l'un d'entre eux étant supérieur ou égal à un.

Une voie optique guidée peut être un guide optique ou une fibre optique.

L'élément optique mobile peut être une lame optique semi-réfléchissante, un miroir, un obturateur, un prisme, une lentille.

La présente invention concerne également un brasseur optique qui comporte une pluralité de dispositifs optiques ainsi caractérisés, ces dispositifs optiques étant disposés en lignes et colonnes, la structure optique de guidage de chaque dispositif optique comportant deux voies optiques guidées disposées selon un angle non nul d'un même côté de l'élément optique mobile et deux voies optiques guidées disposées selon un angle non nul d'un autre côté de l'élément optique mobile, lesdits dispositifs optiques étant reliés en ligne et/ou en colonne par leurs voies optiques respectives.

La présente invention concerne également un procédé de réalisation d'un dispositif optique ainsi caractérisé. Ce procédé comporte les étapes suivantes :
sur un premier substrat réalisation de la structure optique de guidage,
gravure d'une cavité dans laquelle débouche la structure optique de guidage et réalisation de la première référence mécanique,
réalisation d'électrodes pour les moyens de mise en relation,
à partir d'un second substrat, délimitation d'un bloc mobile incluant la seconde référence mécanique liée à l'élément optique mobile et le support flexible,
assemblage du premier substrat et du second substrat retourné,
libération du bloc mobile en conservant une liaison mécanique avec le premier substrat,
à partir d'un troisième substrat réalisation d'une électrode des moyens de déplacement,
assemblage, au-dessus du second substrat, d'un couvercle au fond duquel se trouve l'électrode des moyens de déplacement.

Il comporte également une étape de dépôt d'un matériau diélectrique pour protéger les électrodes.

Le second substrat et le troisième substrat seront avantageusement des substrats SOI.

L'étape de libération du bloc mobile peut inclure un amincissement.

Les électrodes peuvent être déposées sur le premier substrat avant la réalisation de la structure optique de guidage et la gravure de la cavité dans laquelle débouche la structure optique de guidage.

L'étape de gravure peut être suivie d'une étape de gravure de rainures en V dans le premier substrat matérialisant la première référence mécanique.

Dans une autre configuration, les électrodes peuvent être réalisées après l'étape de gravure.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A, 1B (déjà décrites) illustrent le principe d'un dispositif optique à fonction de commutateur de l'art antérieur et la figure 1C est un brasseur optique comportant plusieurs dispositifs optiques de l'art antérieur ;
- les figures 2A, 2B illustrent un dispositif optique de l'invention avant et après le positionnement de l'élément optique mobile par rapport à la structure optique de guidage ;
- la figure 3 illustre un dispositif optique de l'invention dans lequel le dispositif de positionnement est passif ;
- les figures 4A à 4H sont des vues en coupe ou de dessus de plusieurs modes de réalisation de dispositifs optiques selon l'invention dans lesquels le dispositif de positionnement est actif ;
- les figures 5A à 5C, 6A à 6C montrent, en vue de dessus et en coupe, deux autres modes de réalisation d'un dispositif optique selon l'invention dans lesquels la seconde référence mécanique est formée de protubérances et la première référence mécanique de logements pour les protubérances ;
- les figures 7A à 7H illustrent plusieurs configurations possibles pour la structure optique de guidage ainsi qu'un brasseur optique ;
- les figures 8A à 8D illustrent un premier exemple des étapes de réalisation sur un premier substrat de la structure optique de guidage et de la première référence mécanique ;
- les figures 9A à 9C illustrent un premier exemple des étapes de réalisation, à partir d'un second substrat, du bloc mobile incluant l'élément optique et la seconde référence mécanique ;
- les figures 10A et 10B montrent l'assemblage du premier substrat des figures 8 au second substrat retourné des figures 9 et la libération du bloc mobile ;
- les figures 11A à 11D montrent, à partir d'un troisième substrat, la réalisation d'une électrode des moyens de déplacement et le façonnage d'un couvercle ;
- les figures 12A et 12B montrent l'assemblage du troisième substrat des figures 11 aux deux premiers substrats des figures 10 et la réalisation de trous pour des reprises de contact ;
- les figures 13A à 13D illustrent un second exemple de réalisation, sur un premier substrat, de la structure optique de guidage et de la première référence mécanique ;
- les figures 14A, 14B illustrent un second exemple des étapes de réalisation, à partir d'un second substrat, du bloc mobile incluant l'élément optique et la seconde référence mécanique ;
- les figures 15A, 15B montrent l'assemblage du premier substrat des figures 13 au second substrat retourné des figures 14 et la libération du bloc mobile ;
- les figures 16A, 16B montrent l'assemblage du troisième substrat des figures 11 aux deux premiers substrats des figures 15 et la réalisation de trous pour des reprises de contact.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

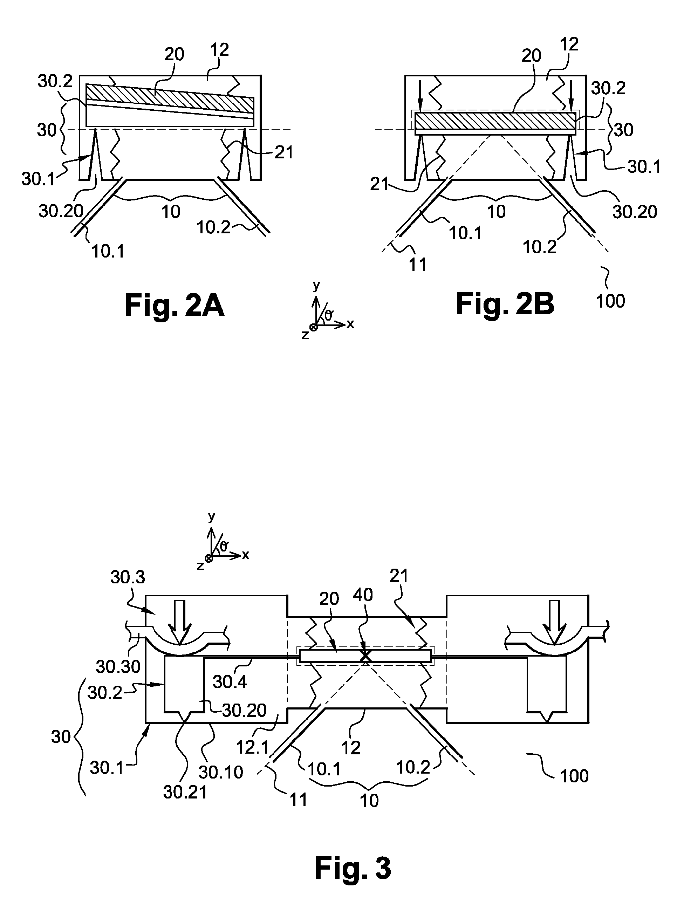

On va maintenant décrire un premier mode de réalisation du dispositif optique objet de l'invention en se référant aux figures 2A, 2B qui sont des vues de dessus. Le dispositif optique représenté comprend une structure optique de guidage 10 comportant au moins une voie optique guidée. Dans l'exemple, il y a deux voies optiques guidées 10.1, 10.2 qui peuvent être des guides optiques ou des fibres optiques. La structure optique de guidage 10 est plane (plan xoy). Les voies optiques guidées sont destinées à véhiculer un faisceau optique 11. Cette structure optique de guidage 10 est fixe par rapport une base 100 avec laquelle elle coopère et qui dans l'exemple est un substrat 100. Elle se trouve au sein du substrat.

Le dispositif optique comporte également un élément optique 20 mobile apte à avoir un mode en interaction avec le faisceau optique 11 et un mode sans interaction avec le faisceau optique 11. Cet élément optique 20 peut être totalement réfléchissant pour le faisceau optique 11, soit autoriser une transmission partielle du faisceau optique 11, soit être absorbant pour le faisceau optique 11. Il peut prendre la forme d'un miroir, d'un prisme, d'une lentille, d'une lame optique semi-réfléchissante, d'un obturateur. Il peut être réalisé en matériau diélectrique, en métal, en matériau semi-conducteur. Il peut comporter un fluide entre deux lames, par exemple un liquide d'indice ou encore un cristal liquide. Lorsque l'élément optique 20 est en interaction avec le faisceau optique 11, il est plongé dans une cavité 12 dans laquelle débouchent les voies optiques guidées 10.1, 10.2 de la structure optique de guidage 10.

L'élément optique 20 est mobile et est relié mécaniquement à la structure optique de guidage 10 qui elle avantageusement est fixe. Cette liaison est généralement indirecte par l'intermédiaire d'un support flexible 21.

Le dispositif optique comporte de plus un dispositif de positionnement 30 de l'élément optique 20 par rapport à la structure optique de guidage 10. Ce dispositif de positionnement 30 comprend au moins une première référence mécanique 30.1 liée à la structure optique de guidage 10 (généralement via la base 100) et une seconde référence mécanique 30.2 liée à l'élément optique mobile 20 et des moyens 30.3 pour mettre en relation la seconde référence mécanique 30.2 et la première référence mécanique 30.1. La mise en relation autorise un mouvement de l'élément optique mobile 20 selon au moins un plan contenant la première référence mécanique 30.1, la seconde référence mécanique 30.2 et la structure optique de guidage 10. Sur ces figures, le mouvement se fait selon au moins une translation dans le plan défini plus haut (plan xoy) et/ou au moins une rotation selon l'axe z. Avec un tel mouvement autorisé, la mise en relation de la seconde référence mécanique avec la première référence mécanique permet un positionnement extrêmement précis de l'élément optique 20 par rapport à la structure optique de guidage 10. Ce n'était pas le cas dans l'art antérieur dans lequel il n'était pas spécifiquement prévu de dispositif de positionnement et de plus le mouvement de l'élément optique 20 ne pouvait se faire que dans un plan perpendiculaire au plan défini plus haut. Si une déviation angulaire de l'élément optique était introduite involontairement, par exemple lors de l'assemblage du substrat portant l'élément optique à celui portant la structure optique de guidage, elle n'était pas éliminée. Ce positionnement grossier entraînait des pertes optiques, ce qui n'était donc pas satisfaisant.

La première référence mécanique 30.1 et la seconde référence mécanique 30.2 peuvent être de type surface et pièce à arête ou à pointes ou autres, les pointes ou l'arête devant venir en contact avec la surface lorsque le dispositif de positionnement 30 a été activé. Dans l'exemple des figures 2A, 2B, la première référence mécanique 30.1 est formée de deux pièces 30.20 dotées chacune d'une arête et la seconde référence mécanique 30.2 est formé d'une surface plane. Ces arêtes sont coplanaires. L'inverse aurait été possible. Une telle vue pourrait schématiser une pièce à pointes au lieu d'une pièce à arête.

La surface plane est une des faces de l'élément optique 20 qui dans cet exemple prend la forme d'un miroir. Sur la figure 2A, le dispositif de positionnement 30 n'a pas encore été activé. L'élément optique 20 n'est pas positionné correctement par rapport à la structure optique de guidage 10 : il doit subir à la fois une translation et au moins une rotation pour atteindre la position recherchée. Sur la figure 2B, le dispositif de positionnement 30 a été activé, la première référence mécanique 30.1 est en relation, dans cet exemple en contact, avec la seconde référence mécanique 30.2. Les moyens 30.3 pour mettre en relation la première référence mécanique 30.1 et la seconde référence mécanique 30.2 ont été représentés par deux flèches qui appliquent des forces coplanaires (plan xoy) à l'élément optique 20. Ces moyens seront détaillés par la suite. Après et/ou avant et/ou même pendant le positionnement, l'élément optique 20 peut être déplacé pour être inséré ou ôté d'une cavité 12 dans laquelle débouche chacune des deux voies optiques guidées 10.1, 10.2 de la structure optique de guidage 10.

Sur la figure 3, on a représenté une autre configuration d'un dispositif optique selon l'invention dans laquelle la première référence mécanique 30.1 est formée de deux surfaces planes et la seconde référence mécanique 30.2 est formée de deux pièces dotées chacune d'une arête. Lors de la mise en relation, les arêtes viennent en contact avec les surfaces planes.

La structure optique de guidage 10, la cavité 12, l'élément optique 20 sont représentés comme sur les figures 2. La première référence mécanique 30.1 est formée de deux surfaces planes orientées perpendiculairement au plan de la structure optique de guidage 10. Dans l'exemple, ces surfaces planes se trouvent dans le plan xoz. Les surfaces sont des parois de cavités auxiliaires 12.1 dans lesquelles la seconde référence mécanique 30.2 est amenée à se mouvoir lors de la mise en relation.

Les surfaces planes pourraient être formées par exemple par des parois de la cavité 12 dans laquelle la structure optique de guidage 10 débouche. On peut envisager qu'une surface corresponde à la surface d'extrémité d'une voie optique guidée de la structure optique de guidage.

La seconde référence mécanique 30.2 est formée de deux pièces 30.20 dotées chacune d'une arête 30.21, ces arêtes sont parallèles, dirigées selon l'axe z et sont situées de part et d'autre de l'élément optique 20. Chacune d'entre elles va venir en contact avec une surface plane 30.10 de la première référence mécanique 30.1. Les pièces 30.20 avec arête sont reliées mécaniquement par une liaison 30.4 par exemple de type bras de liaison à l'élément optique 20. L'élément optique 20 a une forme sensiblement de plaquette et la liaison 30.4 s'étend de part et d'autre de l'élément optique 20. Cette liaison 30.4 peut être flexible mais ce n'est pas une obligation.

Les moyens 30.3 pour mettre en relation la seconde référence mécanique 30.2 avec la première référence mécanique 30.1 peuvent être passifs. La mise en relation peut être effectuée au cours de la fabrication du dispositif optique, par exemple en utilisant des phénomènes de contrainte dans les matériaux. C'est ce mode de réalisation qu'illustre la figure 3. Un élément auxiliaire 30.30 est contraint mécaniquement induisant une déformation irréversible, par exemple de type flambage. Cet élément auxiliaire 30.30 lorsqu'il se déforme vient mettre en relation la seconde référence mécanique 30.2 avec la première référence mécanique 30.1 (c'est à dire mettre en contact l'arête 30.21 avec la surface 30.10). Cette contrainte mécanique induisant le flambage peut être réalisée par effet thermique lors de la fabrication du dispositif optique objet de l'invention. Sur la figure 3 le mouvement autorisé est de même type que celui des figures 2A, 2B.

Dans ce cas, après la mise en relation des première et seconde références mécaniques, le dispositif objet de l'invention est prêt à fonctionner, c'est à dire que l'élément optique 20 étant parfaitement positionné par rapport à la structure optique de guidage 10, il peut interagir ou non avec un faisceau optique 11 guidé par la structure otique de guidage 10. Pour réaliser cette interaction ou au contraire supprimer cette interaction, on prévoit des moyens 40 de déplacement de l'élément optique 20 pour l'introduire ou l'ôter de la cavité 12 et ce déplacement ne doit pas modifier le positionnement qui a été fait entre la seconde référence mécanique et la première référence mécanique. Sur la figure 3, les moyens 40 de déplacement de l'élément optique 20 sont symbolisés par une croix.

En variante, les moyens 30.3 pour mettre en relation la seconde référence mécanique et la première référence mécanique peuvent être actifs comme on le verra ultérieurement et être formés d'actionneurs électrostatiques, électromagnétiques ou autres.

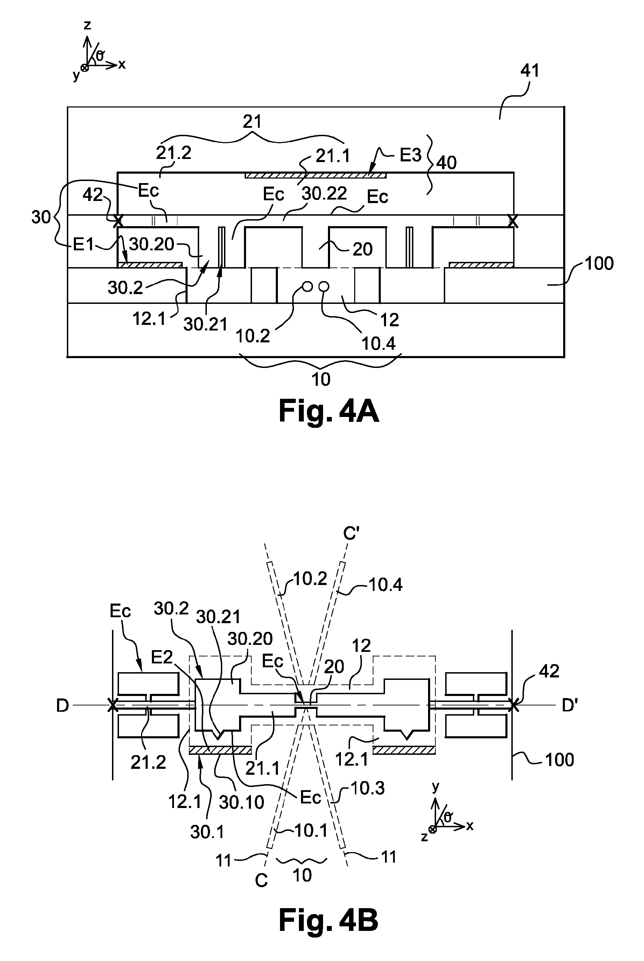

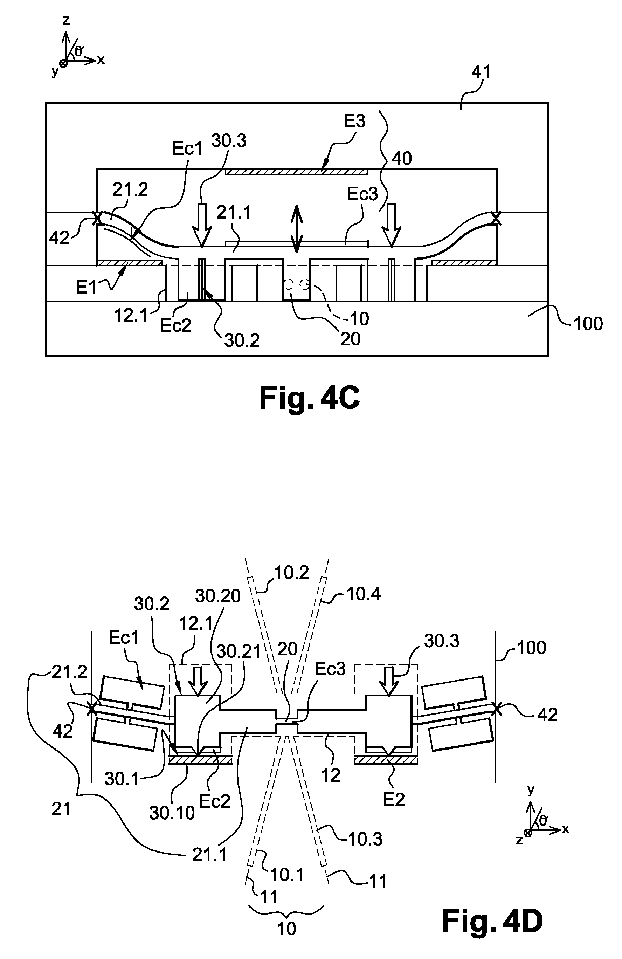

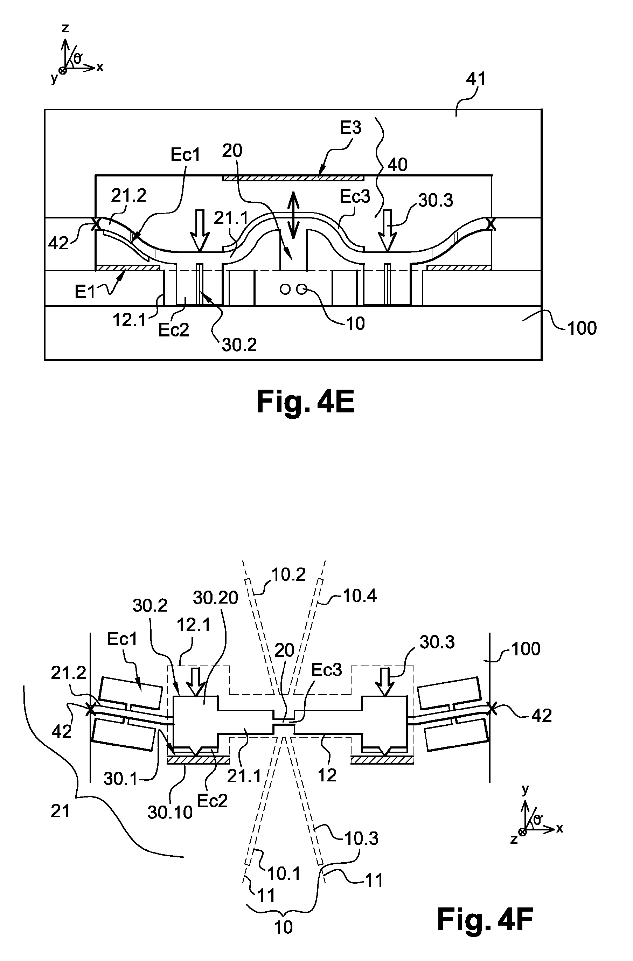

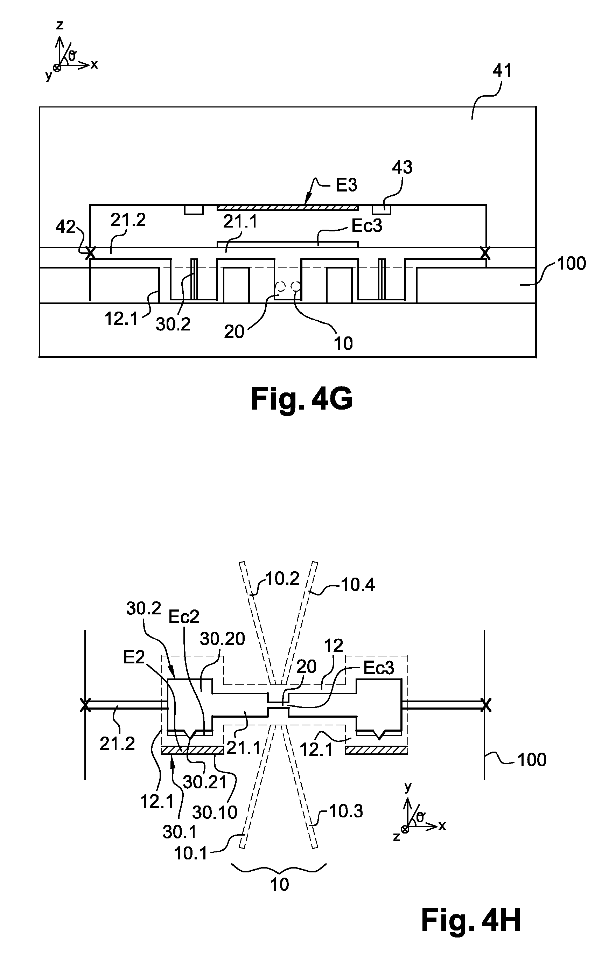

On va maintenant se référer aux figures 4A à 4H. Sur ces figures le dispositif optique objet de l'invention est représenté en coupe et en vue de dessus dans plusieurs configurations. Une première configuration se situe avant la mise en relation de la seconde référence mécanique 30.2 avec la première référence mécanique 30.1. Au repos, par construction, l'élément optique 20 est soit placé hors de la cavité 12 (figures 4A, 4B), soit placé dans la cavité 12 (figures 4G, 4H). Une seconde configuration se situe après la mise en relation de la seconde référence mécanique avec la première référence mécanique. L'élément optique 20 est soit placé dans la cavité (figures 4C, 4D), soit placé hors de la cavité (figures 4E, 4F).

Dans ces exemples, les première et seconde références mécaniques sont comparables à celles des figures 3, à l'exception du fait que les moyens pour mettre en relation les seconde et première références mécaniques sont actifs et de type actionneur électrostatique.

L'élément optique 20 prend la forme d'un miroir double face. Les moyens de déplacement 40 de l'élément optique 20 permettant de le faire plonger ou de le faire sortir de la cavité sont également de type électrostatique.

La structure optique de guidage 10 comporte quatre voies optiques guidées 10.1, 10.2, 10.3, 10.4 arrangées sensiblement en X et coplanaires. Ces quatre voies optiques guidées 10.1, 10.2, 10.3, 10.4 ont une extrémité qui débouche dans la cavité 12. Deux d'entre elles (10.1, 10.3) se trouvent d'un côté de l'élément optique 20 et les deux autres (10.2, 10.4) de l'autre côté de l'élément optique 20 lorsqu'il est plongé dans la cavité 12.

La cavité 12 est creusée dans un substrat 100 sur lequel ou dans lequel prend place la structure optique de guidage 10. La structure optique de guidage s'étend dans le plan xoy. L'élément optique 20 est central et de forme sensiblement plane orienté dans le plan xoz. On suppose que son déplacement pour le mettre ou l'ôter de la cavité 12 se fait dans la direction z. Sur ces figures, il est suspendu au-dessus de la cavité 12 à l'aide d'un support flexible 21 qui le relie à la structure optique de guidage 10 via le substrat 100. Ce support flexible 21 prend la forme de deux bras de liaison 21 situés dans le prolongement l'un de l'autre dans la direction x. La seconde référence mécanique 30.2 prend la forme de deux pièces à arête 30.20 comme sur la figure 3. Chacune de ces pièces 30.20 est reliée à l'élément optique 20 par une liaison flexible 21.1 dans la direction z qui dans cet exemple particulier, fait partie d'un des bras de liaison 21 du support flexible 21. En fait dans cet exemple, chaque bras de liaison 21 comporte deux tronçons 21.1, 21.2. Le tronçon 21.1, proche de l'élément optique, est solidaire d'un côté de l'élément optique 20 et de l'autre de la pièce à arête 30.20. Il est flexible dans la direction z. L'autre tronçon 21.2, éloigné de l'élément optique 20, est solidaire d'un côté de la pièce à arête 30.2 et de l'autre du substrat 100. Il est flexible dans la direction y et dans la direction z. Ici, la liaison flexible entre la seconde référence mécanique 30.2 et l'élément optique 20 est matérialisée par le tronçon 21.1 du support flexible. Dans d'autres configurations cette liaison 30.4 serait distincte du support flexible 21. La liaison entre le support flexible 21 et le substrat 100 peut être un encastrement référencé 42 situé au niveau du tronçon 21.2. Le support flexible 21 relie donc de manière indirecte l'élément optique 20 à la structure optique de guidage 10.

Les moyens 30.3 pour mettre en relation la seconde référence mécanique 30.2 et la première référence mécanique 30.1 sont de type électrostatique. Ils comportent, de chaque côté de l'élément optique 20, deux types de couples d'électrodes (Ec1, E1), (Ec2, E2), les électrodes d'un couple devant s'attirer de manière électrostatique lorsqu'on leur applique une tension de commande. On se réfère plus particulièrement aux figures 4C et suivantes. Les couples d'électrodes d'un type sont perpendiculaires aux couples d'électrodes de l'autre type. L'une Ec1, Ec2 des électrodes d'un couple est mobile, c'est à dire solidaire du support flexible 21 et/ou de la liaison flexible 30.4 et/ou de la seconde référence mécanique 30.2. Dans les exemples, l'une des électrodes mobiles Ec1 est solidaire du tronçon 21.2 du support flexible 21 à proximité de l'encastrement 42. L'autre électrode mobile Ec2 est solidaire de la pièce à arête 30.20.

L'autre électrode E1, E2 d'un couple est fixe, elle est solidaire du substrat 100. L'application d'une tension de commande entre chacun de ces couples d'électrodes (Ec1, E1), (Ec2, E2) engendre un mouvement de la seconde référence mécanique 30.2 vers la première référence mécanique 30.1, ce mouvement pouvant être en trois dimensions pour autoriser translation et rotation de l'élément optique 20 lors de la mise en relation. Comme affirmé précédemment, les électrodes fixes E1, E2 des deux couples sont situées dans deux plans perpendiculaires à savoir le plan xoz (plan dans lequel se déplace l'élément optique 20 pour pénétrer et sortir de la cavité 12) et le plan xoy (plan de la structure optique de guidage 10). Eventuellement l'une des électrodes d'un couple est recouverte de matériau diélectrique, comme on le verra plus tard, pour protéger électriquement les électrodes en cas de contact mécanique entre électrodes.

Les bras de liaison 21 doivent être flexibles dans les directions d'attraction de chacun des couples d'électrodes à savoir dans la direction z (direction d'attraction des couples Ec1, E1) et dans la direction y (direction d'attraction du couple Ec2, E2). D'autres explications sur la flexibilité des bras de liaison seront données plus loin.

L'une des électrodes fixes E1, réalisée sur le substrat 100 et orientée dans le plan de la structure optique de guidage 10 (plan xoy), se trouve à proximité de l'encastrement 42 du support flexible 21 dans le substrat 100.

L'autre électrode fixe E2 réalisée sur le substrat 100 et orientée perpendiculairement à la structure optique de guidage 10 dans le plan de déplacement de l'élément optique 20 (plan xoz) se trouve au niveau de la pièce avec arête 30.20.

Les électrodes quelles soient fixes ou mobiles peuvent être réalisées par des métallisations localisées.

Au lieu d'avoir des électrodes mobiles distinctes Ec1, Ec2 comme sur les figures 4C à 4H, sur les figures 4A, 4B, les électrodes mobiles peuvent former une unique électrode Ec commune. En fait, le support flexible 21, l'élément optique 20 lié à la seconde référence mécanique 30.2 forment un bloc mobile qui est une unique électrode Ec mobile. Ce bloc mobile peut par exemple être réalisé en matériau semi-conducteur éventuellement dopé ou en métal. Dans d'autres configurations dans lesquelles le bloc mobile ne serait pas assez conducteur, l'électrode commune Ec pourrait être déposée sur le bloc mobile. Cette électrode Ec est ainsi commune aux deux couples. Lors de la commande, cette électrode Ec pourra être portée à un potentiel prédéterminé, de préférence la masse, alors que chacune des électrodes fixes E1, E2 seront portées à des potentiels appropriés, généralement différents pour engendrer le mouvement approprié de l'élément optique lors de la mise en relation de la seconde référence mécanique 30.2 et de la première référence mécanique 30.1.

Sur les figures 4A, 4B aucun positionnement n'a été effectué entre l'élément optique 20 et la structure optique de guidage 10. La seconde référence mécanique 30.2 et la première référence mécanique 30.1 n'ont pas encore été mises en relation. Elles sont non jointives. De plus, l'élément optique 20 est situé hors de la cavité 12. Le dispositif optique objet de l'invention n'est pas prêt à fonctionner.

Sur les figures 4C, 4D, la seconde référence mécanique 30.2 et la première référence mécanique 30.1 ont été mises en relation et en outre, l'élément optique 20 a plongé dans la cavité 12. Des tensions de commande appropriées ont été appliquées sur les couples d'électrodes E1, Ec1 et E2, Ec2. La pièce avec arête 30.20 est venue se plaquer contre la surface 30.10 matérialisant la première référence mécanique. Dans cet exemple, lors de la mise en relation, la seconde référence mécanique se meut dans un espace 12.1 qui est une extension de la cavité 12. C'est pourquoi, la surface plane faisant office de première référence mécanique peut être assimilée à une paroi de la cavité dans laquelle débouchent les voies optiques guidées 10.1 à 10.4. En variante, il pourrait s'agir d'une paroi d'une cavité auxiliaire dans laquelle se meut la pièce avec arête 30.20 lors de la mise en relation. Toutefois, il est plus simple que l'espace 12.1 communique avec la cavité 12. Cette surface est recouverte d'une métallisation matérialisant l'électrode fixe E2. A ce stade, l'électrode Ec2 peut être très proche de l'électrode E2.

Quant aux électrodes E1, Ec1 de l'autre couple, elles se sont rapprochées par effet électrostatique sans toutefois, dans cet exemple, venir en contact. Le support flexible 21 au niveau de son tronçon extrême 21.2 s'est déformé à la fois dans le plan xoz ainsi que dans le plan xoy.

Le tronçon proche 21.1 lui ne s'est pratiquement pas déformé à ce stade. Il est plus rigide dans la direction y que ne l'est le tronçon éloigné 21.2. Il s'est seulement déplacé dans le plan xoy et dans le plan xoz en entraînant dans sa course l'élément optique 20. Le tronçon proche 21.1 est plus large (dimension selon y) que le tronçon éloigné 21.2 ce qui est une façon d'obtenir les rigidités souhaitées.

L'élément optique 20 a plongé dans la cavité 12. Le dispositif optique est dans un état de réflexion (dans la mesure où l'élément optique 20 est un miroir) puisque l'élément optique 20 est dans la cavité 12. Un faisceau optique 11 véhiculé par la voie optique guidée 10.1 sera renvoyé, après réflexion sur une des faces de l'élément optique 20, vers la voie optique guidée 10.3 qui se trouve du même côté qu'elle par rapport à l'élément optique 20. De la même manière un faisceau optique (non représenté) véhiculé par la voie optique guidée 10.2 sera renvoyé, après réflexion sur l'autre face de l'élément optique 20, vers la voie optique guidée 10.4 qui se trouve du même côté qu'elle de l'élément optique 20. L'angle que fait la surface réfléchissante par rapport au faisceau optique incident est déterminé pour obtenir cette réflexion. On réalise ainsi un aiguillage élémentaire.

Les moyens 40 de déplacement de l'élément optique 20 sont également électrostatiques. Ils comportent un couple d'électrodes Ec3, E3 dont une Ec3 est mobile et l'autre E3 est fixe. L'électrode mobile Ec3 est reliée à l'élément optique 20. Dans l'exemple des figures 4A, 4B, elle est matérialisée par l'électrode commune Ec. Dans l'exemple des figures 4C, 4D et 4E, 4F elle est indépendante. L'électrode fixe E3 est solidaire d'un couvercle de protection 41 qui est fixé au substrat 100 et qui recouvre au moins la cavité 12 et l'élément optique 20. Ce couvercle délimite un espace de commande autour de l'élément optique 10. Cette électrode fixe E3 est localisée face à l'élément optique 20.

L'application d'une tension de commande entre les deux électrodes Ec3 et E3 a pour effet de rapprocher les deux électrodes et donc de fléchir le tronçon proche 21.2 dans le plan xoz (plan dans lequel se déplace l'élément optique 20) et de relever l'élément optique 20 pour le mettre hors de la cavité 12. Ce tronçon proche 21.1 est suffisamment rigide dans le plan xoy (plan de la structure optique de guidage) pour ne pas remettre en question la mise en relation entre la seconde référence mécanique 30.2 et la première référence mécanique 30.1. Les moyens de déplacement 40 de l'élément optique 20, lorsqu'ils sont activés, peuvent déformer le support flexible 21 au niveau du tronçon proche 21.1 et éventuellement du tronçon éloigné 21.2 sans toutefois remettre en cause la mise en relation de la première référence mécanique et la seconde référence mécanique. Cet état est représenté sur les figures 4E, 4F. La déformation du tronçon éloigné 21.2 est à éviter préférentiellement.

Le dispositif optique objet de l'invention est mis dans un état de transmission. Un faisceau optique incident 11 véhiculé par la voie optique guidée 10.1 traverse la cavité 12 et se propage dans la voie optique guidée 10.4 qui se trouve dans son prolongement. Il en est de même pour un faisceau optique qui passerait de la voie optique guidée 10.2 à la voie optique guidée 10.3.

Si l'on veut limiter au maximum les pertes d'insertion, il est préconisé d'introduire un fluide (un liquide ou un gel) adaptateur d'indice au moins dans la cavité 12, ces pertes optiques sont dues à la propagation du faisceau optique dans l'espace compris entre les voies optiques guidées et l'élément optique 20.

La commande électrostatique des moyens 30.3 pour mettre en relation et/ou des moyens de déplacement 40 peut fonctionner dans un domaine stable, c'est à dire qu'au moins une électrode mobile se déplace entre deux positions extrêmes. Par exemple, la tension de commande confère une course prédéterminée à l'électrode mobile Ec3 et dans une de ces positions extrêmes, l'électrode mobile Ec3 ne doit pas dépasser une amplitude de déformation prédéterminée au delà de laquelle, si on augmente la tension de commande, l'électrode mobile Ec3 va se déplacer jusqu'au contact avec l'électrode fixe si rien ne l'arrête. L'autre position extrême correspond au cas où l'élément optique 20 est en butée au fond de la cavité 12.

En variante, la commande électrostatique peut fonctionner dans un domaine instable. Dans cette configuration, l'électrode mobile Ec3 aura une course qui permet d'exploiter toute l'amplitude inter électrodes. L'électrode mobile Ec3 peut être stoppée par des plots isolants référencés 43 sur la figure 4G ou analogue. On peut penser par exemple à un contrôle par une structure de type à rigidité variable comme dans la demande de brevet français FR-2 818 825 ou à une électrode mobile à effet zipping, c'est à dire à placage progressif de l'électrode mobile sur l'électrode fixe à partir de son extrémité.

Sur les figures 4A à 4F, le mouvement autorisé se fait dans le plan xoy et le plan xoz pour les translations et selon l'axe z et l'axe y pour les rotations.

On se réfère aux figures 4G, 4H. La configuration représentée maintenant, voisine de celle des figures 4A, 4B, en diffère en ce que l'élément optique 20 est placé dans la cavité 12, avant même la mise en relation entre la seconde référence mécanique 30.2 et la première référence mécanique 30.1. Les moyens 30.3 pour mettre en relation la seconde référence mécanique 30.2 avec la première référence mécanique 30.1 ne comportent maintenant qu'un seul type de couples d'électrodes, celui dont l'électrode mobile Ec2 se trouve au voisinage de la seconde référence mécanique 30.2 et qui permet un déplacement dans le plan de la structure optique de guidage. L'autre type de couples d'électrode est maintenant superflu. Dans chaque couple, l'électrode fixe E2 se trouve au niveau de chacune des surfaces de référence de la première référence mécanique 30.1 et l'électrode mobile Ec2 se trouve au voisinage de l'arête de la pièce avec arête 30.20. Dans le dispositif optique, il y a donc deux couples d'électrodes (Ec2, E2) d'un même type qui permettent le positionnement recherché de l'élément optique 20 par rapport à la structure optique de guidage 10. Sur les figures 4G, 4H le mouvement autorisé est un mouvement dans le plan contenant la première et la seconde références mécaniques 30.1, 30.2 et la structure optique de guidage 10.

Ainsi une translation de la seconde référence mécanique 30.2 dans la direction z perpendiculaire au plan de la structure optique de guidage 10 n'est pas nécessaire lors de la mise en relation de la seconde référence mécanique 30.2 et de la première référence mécanique 30.1 puisque l'élément optique 20 au repos, se trouve par construction dans la cavité 12.

Les moyens de déplacement 40 de l'élément optique 20 ont été représentés sensiblement de même nature que sur les figures précédentes. Dans la présente configuration des figures 4G, 4H, il est alors possible de réduire l'espace entre l'électrode Ec3 et l'électrode E3. La tension de commande à fournir aux moyens 40 de déplacement de l'élément optique 20 peut être moindre. Cela facilite la commande fonctionnelle du dispositif optique, c'est à dire par exemple son passage de l'état de transmission à l'état de réflexion.

Des géométries particulières d'électrodes mobiles peuvent être mises en oeuvre pour optimiser le fonctionnement du dispositif optique selon l'invention. A titre d'exemple on peut se référer à la demande de brevet FR-2 817 050 qui montre des configurations d'électrodes.

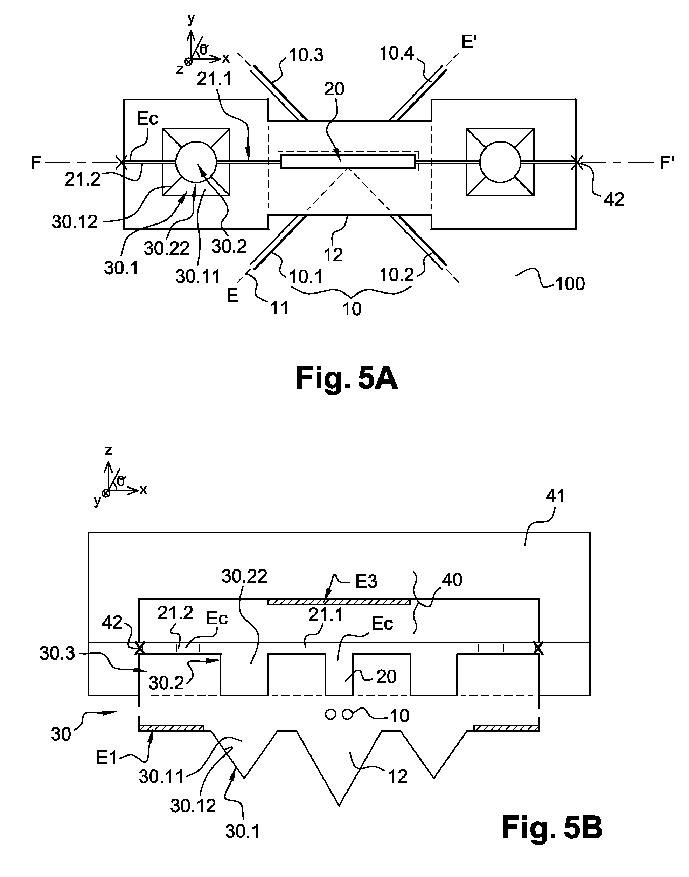

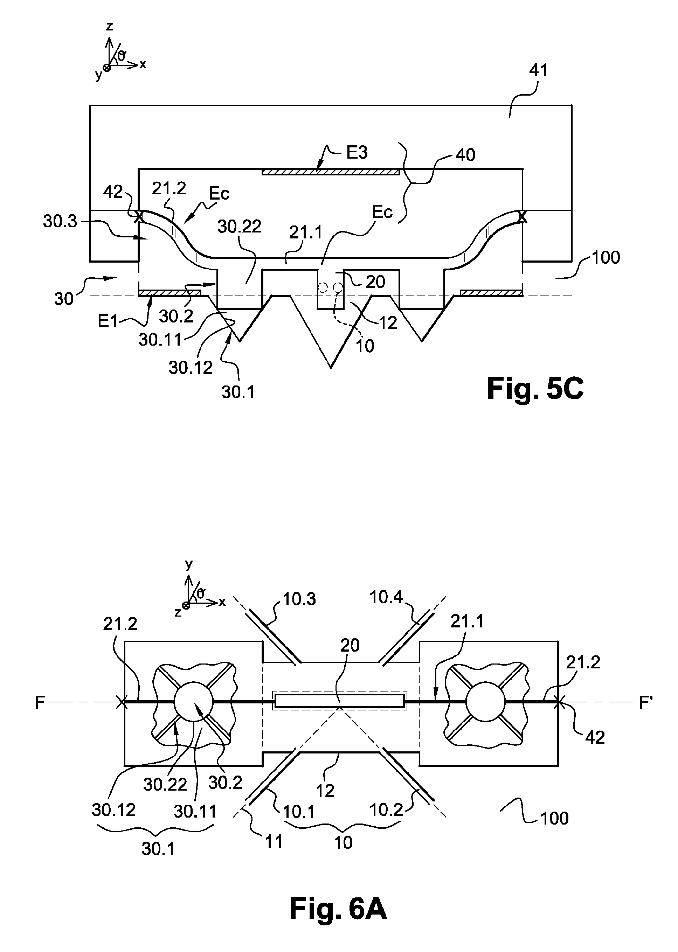

On va maintenant s'intéresser à des variantes de la seconde référence mécanique et de la première référence mécanique. On se réfère aux figures 5A, 5B, 5C qui montrent, de manière schématique, respectivement une vue de dessus et des vues en coupe avant et après mise en relation des première et seconde références mécaniques d'un dispositif optique selon l'invention.

La seconde référence mécanique 30.2 comporte une ou plusieurs protubérances 30.22. La première référence mécanique 30.1 est formée d'un ou plusieurs logements 30.11, chacun devant accueillir une protubérance 30.22 lors de la mise en relation. Les logements 30.11, tout comme le fond de la cavité 12, sont creusés dans le substrat 100 accueillant la structure optique de guidage 10. Chaque logement 30.11 est équipé de moyens de guidage mécanique 30.12 d'une protubérance 30.22 dans un logement. Dans cet exemple, les logements 30.11 sont des rainures en V et les moyens de guidage 30.12 les parois inclinées des rainures. Chaque protubérance 30.22 a la forme d'un cylindre de révolution mais d'autres formes seraient possibles. Chaque protubérance 30.22 est guidée par les parois de la rainure dans laquelle elle pénètre et ce guidage contribue à réaliser le positionnement en trois dimensions de l'élément optique 20 par rapport à la structure optique de guidage 10. La protubérance 30.22 est ainsi centrée par les parois en V de la rainure.

Chaque protubérance 30.22 est solidaire de l'élément optique 20 par l'intermédiaire d'une liaison flexible 21.1. L'élément optique 20 est suspendu au-dessus de la cavité 12, dans laquelle il peut plonger, par un support 21, flexible au moins selon la direction z, relié à la structure optique de guidage 10. Ce support flexible 21 peut englober la liaison flexible 21.1 comme sur les figures 4 et prendre la forme, de part et d'autre de l'élément optique 20, d'un bras de liaison formé de deux tronçons 21.1, 21.2 situés de part et d'autre d'une protubérance 30.22.

Sur la figure 5B, la mise en relation de la seconde référence mécanique 30.2 et de la première référence mécanique 30.1 n'a pas eu lieu. L'élément optique 20 est en dehors de la cavité 12. Sur la figure 5C, elle a eu lieu et l'élément optique 20 est en position pour intercepter un faisceau optique 11 véhiculé par une voie optique guidée de la structure optique de guidage 10.

Les moyens 30.3 pour mettre en relation la seconde référence mécanique 30.2 par rapport à la première référence mécanique 30.1 sont de type électrostatique et comportent au moins un couple d'électrodes avec une électrode mobile Ec solidaire du support flexible 21 et au moins une électrode fixe E1 solidaire du substrat 100 qui porte la structure optique de guidage 10. Ces électrodes E1, Ec s'étendent dans le plan de la structure optique de guidage 10 (plan xoy) et permettent un mouvement selon z. Il n'y a pas d'autres couples d'électrodes dans d'autres plans pour les moyens de mise en relation à cause de la présence de moyens de guidage. Les moyens de déplacement 40 de l'élément optique 20 ont été représentés comme sur les figures 4.

La cavité 12 dans laquelle débouchent les voies optiques guidées de la structure optique de guidage 10 a également été représentée avec un fond en V. De telles formes en V sont aisément réalisables par des techniques de gravure, préférentiellement selon des plans cristallins, dans un substrat en matériau semi-conducteur.

Les rainures en V peuvent être bornées par des parois orientées selon le plan xoz ou bien avec des parois inclinées comme le montre la figure 5A. Ces rainures bornées forment une pyramide en creux à base carrée. Ces parois inclinées affinent le positionnement de l'élément optique par rapport à la structure optique de guidage. Sur les figures 5A à 5C, le mouvement autorisé est selon les plans xoz et xoy pour les translations et selon au moins l'axe z pour la rotation.

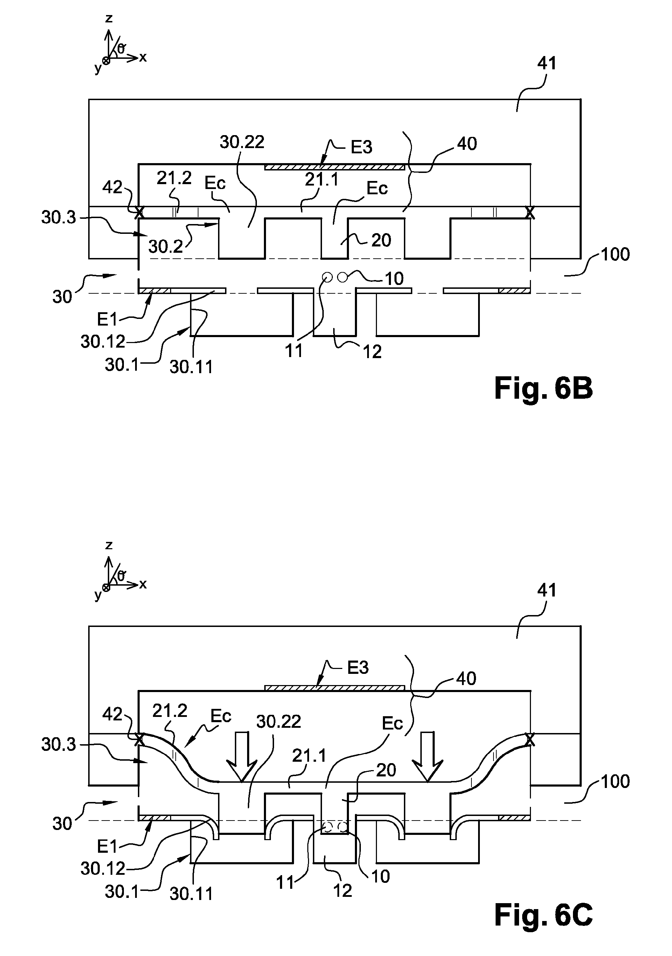

Les figures 6A, 6B, 6C sont comparables aux figures 5A, 5B, 5C, les mêmes mouvements sont autorisés. Une différence se situe au niveau de la première référence mécanique 30.1 qui est toujours de type logement. La seconde référence mécanique mobile 30.2 est formée comme précédemment d'une ou plusieurs protubérances 30.22, de préférence en forme de cylindre de révolution. Chaque protubérance 30.22 est destinée à pénétrer dans un logement 30.11 équipé de moyens de guidage mécanique 30.12 de la protubérance 30.22. Les logements 30.11 en forme de puits sont creusés dans le substrat 100. Les moyens de guidage mécanique 30.12 prennent la forme de plusieurs languettes souples qui pendent dans chaque logement depuis son ouverture lorsque la protubérance est introduite dans le logement. Ces languettes souples 30.12 ont une extrémité libre qui se trouve dans le logement 30.11. Ces languettes souples 30.12 guident les protubérances lors de la mise en relation de la seconde référence mécanique 30.2 et de la première référence mécanique 30.1. Leur rôle est de centrer la protubérance 30.22 dans son logement 30.11.

On va maintenant s'attacher à décrire différentes configurations de la structure optique de guidage 10. Cette structure optique de guidage comporte n voies optiques guidées 10.10 d'un côté de l'élément optique 20 plongé dans la cavité 12 et m voies optiques guidées 10.20 d'un autre côté de l'élément optique 20. n et m sont des nombres entiers dont au moins un est supérieur ou égal à un. Cette structure optique de guidage est plane (plan xoy).

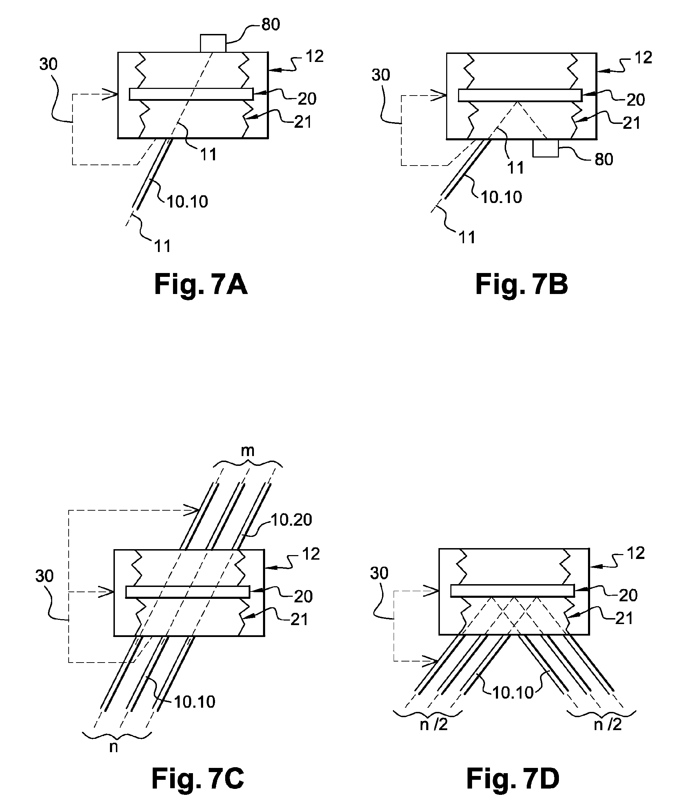

La configuration la plus simple ne comporte qu'une seule voie optique guidée 10.10 comme sur la figure 7A. La voie optique guidée 10.10 qui peut être une fibre optique ou un guide optique débouche dans la cavité 12. Dans son prolongement, de l'autre côté de la cavité, peut se trouver un organe 80 tel un détecteur de lumière destiné à être illuminé par un faisceau optique 11 véhiculé par la voie optique guidée 10.10. L'élément optique 20 a alors une fonction d'obturateur. Lorsqu'il se trouve dans la cavité 12, il stoppe la propagation du faisceau optique 11 vers l'organe 80. Lorsqu'il est hors de la cavité 12, le faisceau 11 peut atteindre l'organe 80. Ce dernier état est celui illustré sur la figure 7A.

Dans une variante illustrée sur la figure 7B, l'organe 80 peut être placé du même côté que la voie optique guidée 10.10 par rapport à l'élément optique 20 plongé dans la cavité 12. Dans ce cas, l'élément optique 20 peut avoir une fonction de réflexion du faisceau optique 11 vers l'organe 80. C'est cet état qui est illustré. Le dispositif de positionnement 30 a été esquissé sur les figures 7A à 7G.

Les figures 2A, 2B montrent deux voies optiques guidées d'un côté de l'élément optique et aucune de l'autre. Ces voies optiques guidées forment un angle. L'élément optique 20 a une fonction de réflecteur.

Les figures 4 montrent deux voies optiques de chaque côté de l'élément optique 20 plongé dans la cavité 12. Le dispositif optique est un commutateur qui fonctionne en réflexion lorsque l'élément optique 20 est dans la cavité 12 et en transmission lorsque l'élément optique 20 est hors de la cavité 12.

Sur la figure 7C, il y a n voies optiques guidées 10.10 d'un côté de l'élément optique 20 plongé dans la cavité 12 et m voies optiques guidées 10.20 d'un autre côté. n est égal à m et supérieur ou égal à un. Chacune des m voies optiques guidées 10.20 est dans le prolongement d'une des n voies optiques guidées 10.10. Ces voies optiques 10.10, 10.20 forment un angle avec l'élément optique 20. Ce dispositif optique fonctionne en obturateur sur n voies.

La figures 7D est une généralisation de la structure de la figure 2 avec deux groupes de n/2 voies optiques guidées 10.10 d'un même côté de l'élément optique 20 plongé dans la cavité 12, ces deux groupes forment un angle. Un tel dispositif optique fonctionne en réflexion sur n/2 voies.

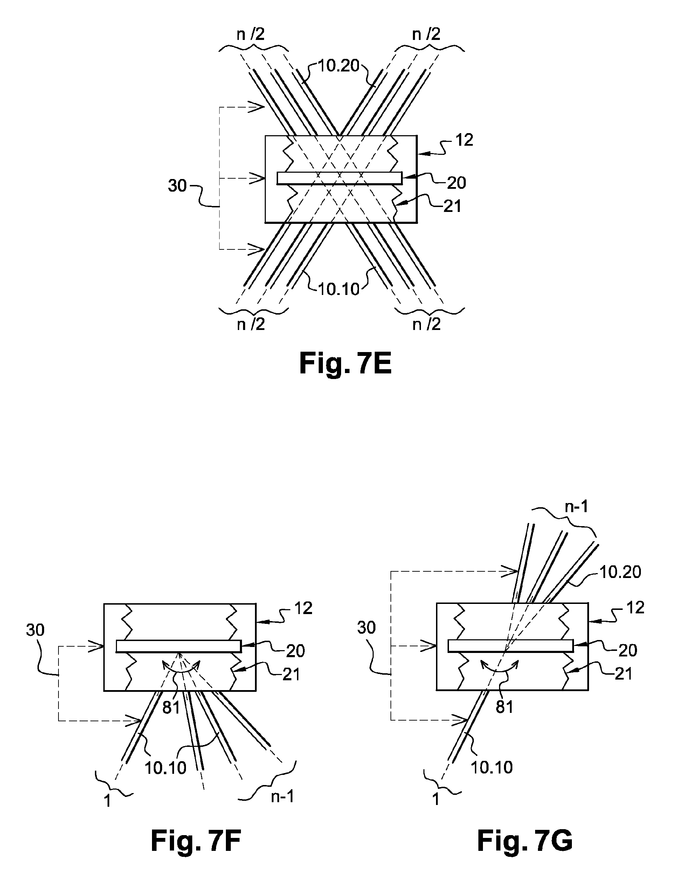

La figure 7E est une généralisation de la structure des figures 4 avec deux groupes de n/2 voies optiques 10.10 formant un angle et placés d'un côté de l'élément optique 20 plongé dans la cavité 12 et deux groupes de n/2 voies optiques 10.20 formant le même angle et placées de l'autre côté. Un groupe de n/2 voies optiques guidées 10.10 ou 10.20 d'un côté de l'élément optique 20 est dans le prolongement d'un groupe de n/2 voies optiques guidées 10.20 ou 10.10 placé de l'autre côté de l'élément optique 20. Un tel dispositif fonctionne en commutateur sur n voies, soit en transmission soit en réflexion.

Les figures 7F et 7G illustrent encore d'autres configurations du dispositif optique objet de l'invention qui maintenant a une fonction de commutateur 1xn.

Sur la figure 7F, la structure optique de guidage comporte d'un même côté de l'élément optique 20 placé dans la cavité 12, d'une part une unique voie optique guidée 10.10 et d'autre part un groupe de n-1 voies optiques guidées 10.10.

L'élément optique 20 peut être un miroir. Il est apte à prendre plusieurs positions angulaires autour de l'axe z manière à ce que chacune des n voies optiques guidées 10.10 puisse être sélectionnée. Le dispositif optique fonctionne en réflexion et est réversible.

Sur la figure 7G, il y a d'un côté de l'élément optique 20 plongé dans la cavité 12 une unique voie optique guidée 10.10 et de l'autre côté de l'élément optique 20 un groupe de m (= n-1) voies optiques guidées 10.20. L'élément optique 20 peut être une lame diélectrique transparente ou semi-transparente. Elle est apte à prendre plusieurs positions angulaires autour de l'axe z de manière à ce que chacune des m voies optiques guidées 10.20 puisse être sélectionnée. Le dispositif optique fonctionne en transmission et est réversible.

Sur ces deux figures, les moyens pour déplacer l'élément optique 20 en rotation n'ont pas été détaillés, ils sont schématisés par une double flèche 81.

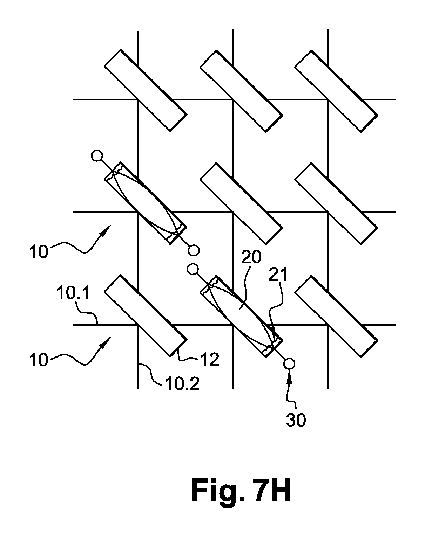

La présente invention concerne également un brasseur optique qui comporte une pluralité de dispositifs optiques ainsi caractérisés. Ces dispositifs optiques sont disposés en lignes et colonnes, la structure optique de guidage 10 comportant deux voies optiques guidées 10.1, 10.2 disposées selon un angle non nul d'un même côté de l'élément optique mobile 20 et deux voies optiques 10.3 et 10.4 disposées selon un angle non nul d'un autre côté de l'élément optique mobile 20. Les différentes voies optiques 10.1 à 10.4 débouchent dans une cavité 12 et permettent en outre de relier optiquement selon des lignes et/ou des colonnes les dispositifs optiques. La figure 7H illustre un tel brasseur optique. Ses deux éléments optique mobiles 20 sont plongés dans une des cavités 12. Les supports flexibles portent la référence 21 et le dispositif de positionnement la référence 30.

On va maintenant décrire un exemple de procédé de réalisation d'un dispositif optique conforme à l'invention. Le dispositif optique réalisé est comparable à celui des figures 4A, 4B avec une unique électrode mobile Ec massive formée du bloc mobile à savoir de l'élément mobile, du support flexible, des pièces à arête et de la liaison flexible. Toutefois des différences existent.

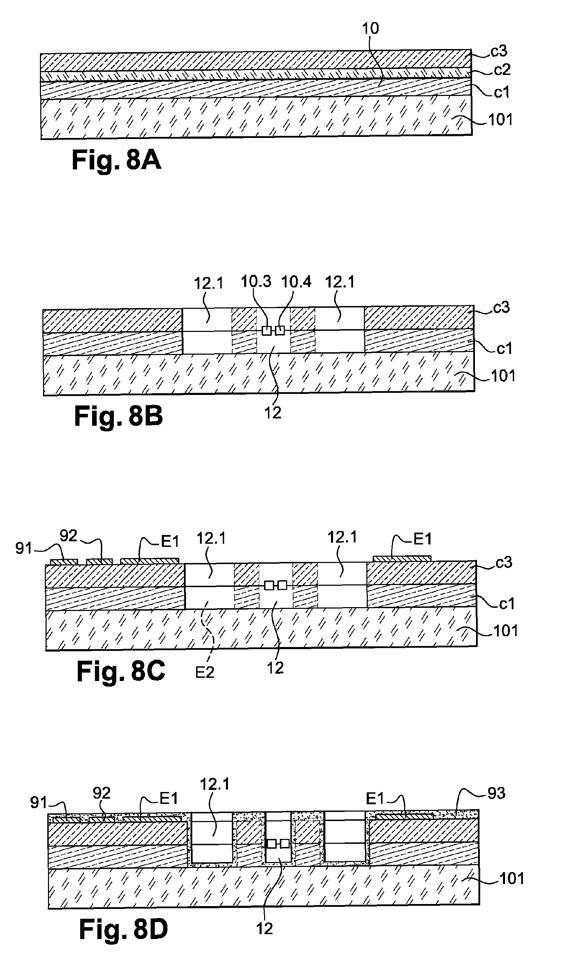

On commence par réaliser sur un premier substrat 101, la structure optique de guidage 10. Cette structure optique de guidage 10 comporte quatre voies optiques guidées en croix chacune prenant la forme d'un guide optique plat avec un coeur et un enrobage. Sur le substrat de base 101 par exemple en silicium, on dépose une première couche c1 qui va servir d'enrobage, on la recouvre d'une seconde couche c2 qui va servir de coeur et qui va ensuite être gravée pour délimiter le contour du coeur. Le coeur peut être de section circulaire ou rectangulaire selon la technologie employée, dans la technologie sur silicium la section du coeur est plutôt rectangulaire et dans la technologie sur verre, elle est plutôt circulaire. La seconde couche c2 est recouverte d'une troisième couche c3 qui sert d'enrobage (figure 8A). Cette figure est une coupe le long de l'axe CC' représenté sur la figure 4B. Les voies optiques guidées 10.3, 10.4 sont représentées mises bout à bout car à ce stade la cavité n'a pas été réalisée.

Les couches c1, c2, c3 peuvent être en différents matériaux dopés ou non, la seconde couche c2 devant présenter un indice de réfraction supérieur à celui des autres couches c1, c3 de façon à assurer le guidage de la lumière. A titre d'exemple, ces matériaux peuvent être choisis parmi du verre, de l'oxyde de silicium, du silicium, des polymères.

On va ensuite délimiter par gravure la cavité 12 devant accueillir l'élément optique mobile et l'espace 12.1 dans lequel évolue la seconde référence mécanique (prenant la forme de pièces avec arête) et ainsi matérialiser la première référence mécanique qui est une paroi qui délimite cet espace. Sur la figure 4B, on voit que cet espace 12.1 communique avec la cavité 12 mais ce n'est pas une obligation. L'espace 12.1 et la cavité 12 sont distincts. La figure 8B est une coupe transversale du dispositif le long de l'axe DD' de la figure 4B. Cette gravure peut être une gravure sèche anisotrope. Elle s'arrête sur le premier substrat 101. Sur cette figure, on aperçoit de face en coupe transversale seulement la voie optique guidée 10.2 et la voie optique guidée 10.4.

On va ensuite réaliser des électrodes fixes E1, E2 des moyens de mise en relation de la seconde référence mécanique avec la première référence mécanique (figure 8C). Ces électrodes sont conformes à celles des figures 4A, 4B. L'électrode E2 n'est pas visible car elle se trouve dans le plan de la feuille. Cette réalisation d'électrodes peut se faire par évaporation ou pulvérisation, à travers un masque mécanique (non représenté), d'un matériau conducteur à base d'aluminium, de titane, de nickel, d'or par exemple. On prévoit reliées à ces électrodes E1, E2 des plots conducteurs d'accès 91, 92 à chacune des électrodes.

On va ensuite déposer une couche diélectrique 93 sur ces électrodes E1, E2 et ces plots 91, 92 pour les protéger lors du fonctionnement électromécanique du dispositif optique. Cette couche d'oxyde peut également être utilisée pour le scellement de ce premier substrat 101 avec un second substrat 102 qui sera décrit ultérieurement. On peut réaliser par exemple un dépôt d'oxyde conforme de BPSG, abréviation de bore phosphore silicate glass soit verre de borophosphosilicate, d'oxyde de silicium dopé au bore et au phosphore ou analogue. Une étape de planarisation de la couche d'oxyde en surface peut être effectuée en vue de préparer la surface pour le scellement avec le second substrat 102 (figure 8D).

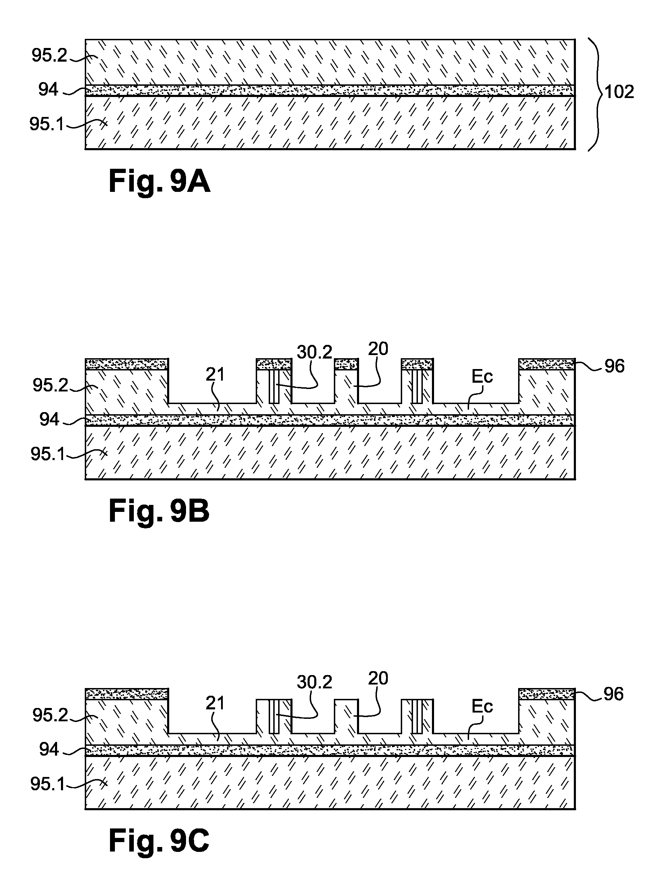

On part d'un second substrat 102 comportant une couche diélectrique intermédiaire 94 entre deux couches de matériau semi-conducteur : une couche inférieure 95.1 et une couche supérieure 95.2. Il peut s'agir par exemple, d'un substrat SOI (silicon on insulator soit silicium sur isolant) épais 102 dont l'épaisseur de la couche de silicium 95.2 est d'environ 20 micromètres et dont l'épaisseur de la couche d'oxyde de silicium 94 enterrée est d'environ 1 micromètre (figure 9A). On délimite par gravure l'élément optique 20, la seconde référence mécanique 30.2, le support flexible 21 et si nécessaire la liaison flexible (si elle n'est pas englobée dans le support flexible) (figure 9B). La gravure peut être par exemple une gravure sèche anisotrope à travers un masque d'oxyde 96 par exemple de l'oxyde de silicium. La gravure s'arrête au sein de la couche supérieure 95.2 de matériau semi-conducteur.

On dégage ensuite le masque d'oxyde 96 sur les parties gravées amenées à se mouvoir, à savoir le support flexible 21, la seconde référence mécanique 30.2 et l'élément optique 20, c'est à dire le bloc mobile (figure 9C). Cela peut se faire par gravure sèche ou humide de l'oxyde après avoir protégé le reste de la couche d'oxyde par exemple par une couche de résine. On suppose que le bloc mobile forme une électrode mobile Ec commune aux moyens de mise en relation et aux moyens de déplacement.

La figure 10A illustre l'assemblage entre le premier substrat 101 portant la structure optique de guidage 10 et le second substrat 102 retourné et portant le bloc mobile. Cet assemblage peut être un scellement moléculaire ou analogue un scellement eutectique, un scellement anodique. La précision d'assemblage n'a pas besoin d'être très bonne.

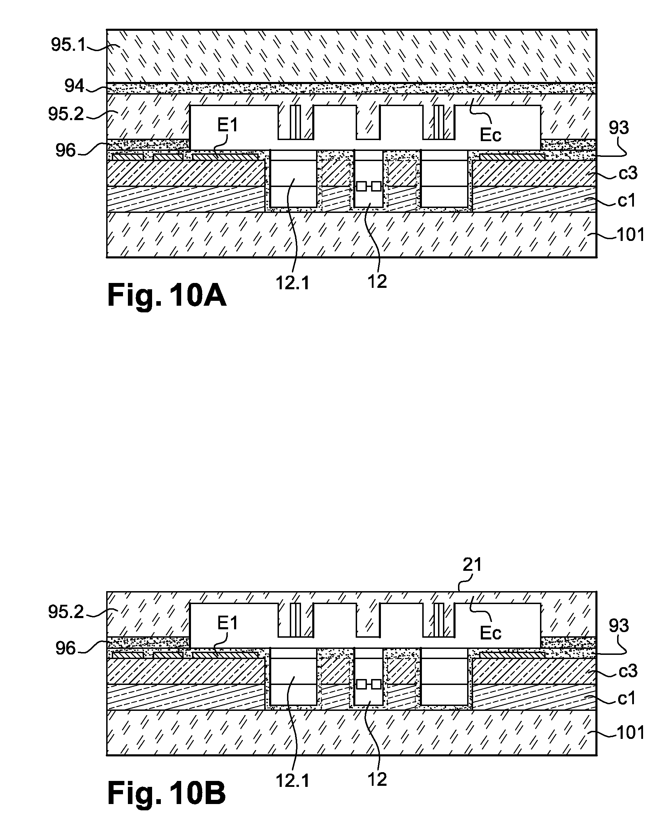

On libère ensuite le bloc mobile par amincissement en ôtant la couche de matériau semi-conducteur inférieure 95.1 et la couche diélectrique intermédiaire 94 puis en délimitant leur contour dans l'épaisseur de la couche de matériau semi-conducteur supérieure qui n'a pas été attaquée à l'étape de la figure 9B (figure 10B). Ces gravures peuvent se faire par une gravure sèche anisotrope. On conserve, de part et d'autre du support flexible 21, du matériau du second substrat car c'est dans ces endroits que se fait le scellement avec le premier substrat 101 de base.

Cette étape de délimitation du contour du bloc mobile risque d'être délicate car il est déjà mobile lorsqu'on a ôté la couche de matériau semi-conducteur inférieure 95.1 et la couche diélectrique intermédiaire 94. Il est possible de procéder à l'inverse en commençant par délimiter le contour du bloc mobile à travers l'épaisseur restante de la couche de matériau semi-conducteur supérieure 95.2 qui n'a pas été attaquée à l'étape de la figure 9B, la couche diélectrique intermédiaire 94 et la couche de matériau semi-conducteur inférieure 95.1 et seulement ensuite d'ôter la couche diélectrique intermédiaire 94 et la couche de matériau semi-conducteur inférieure 95.1. Ces deux couches ont un rôle de rigidificateur. En variante, seule la couche diélectrique intermédiaire 94 peut être considérée comme couche de rigidification. La couche de matériau semi-conducteur inférieure 95.1 peut alors être ôtée avant la délimitation et la couche diélectrique intermédiaire 94 après.

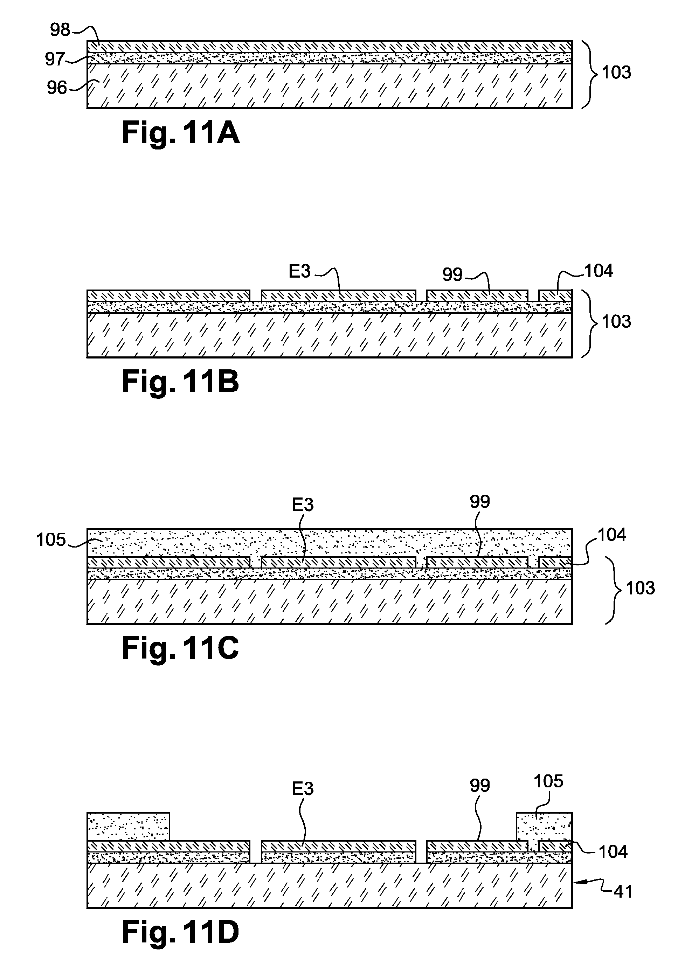

On utilise un troisième substrat 103 comportant une couche épaisse 96 de matériau semi-conducteur recouverte d'une couche mince 97 de matériau isolant et d'une couche mince 98 de matériau semi-conducteur pour réaliser une partie des moyens de déplacement de l'élément optique (figure 11A). Il peut s'agir d'un substrat SOI, l'épaisseur de ses couches minces 97, 98 peut être de l'ordre du micromètre.

On grave dans la couche mince 98 de matériau semi-conducteur (éventuellement dopée pour la rendre plus conductrice) le contour de l'électrode fixe E3 des moyens de déplacement de l'élément optique ainsi qu'un plot d'accès 104 relié à l'électrode fixe (figure 11B) .

On recouvre cette électrode fixe E3 et ce plot 104 d'une couche de matériau diélectrique 105 (figure 11C). Il peut s'agir d'une couche d'oxyde de silicium. Une étape de planarisation de la surface de la couche de matériau diélectrique 105 peut être envisagée.

On façonne dans la couche de matériau diélectrique 105 les parois de l'intérieur du couvercle 41 de manière à délimiter l'espace de commande (figure 11D). Ce façonnage peut être une gravure sèche anisotrope de la couche de matériau diélectrique 105. La gravure met à nu l'électrode fixe E3 mais pas le plot 104.

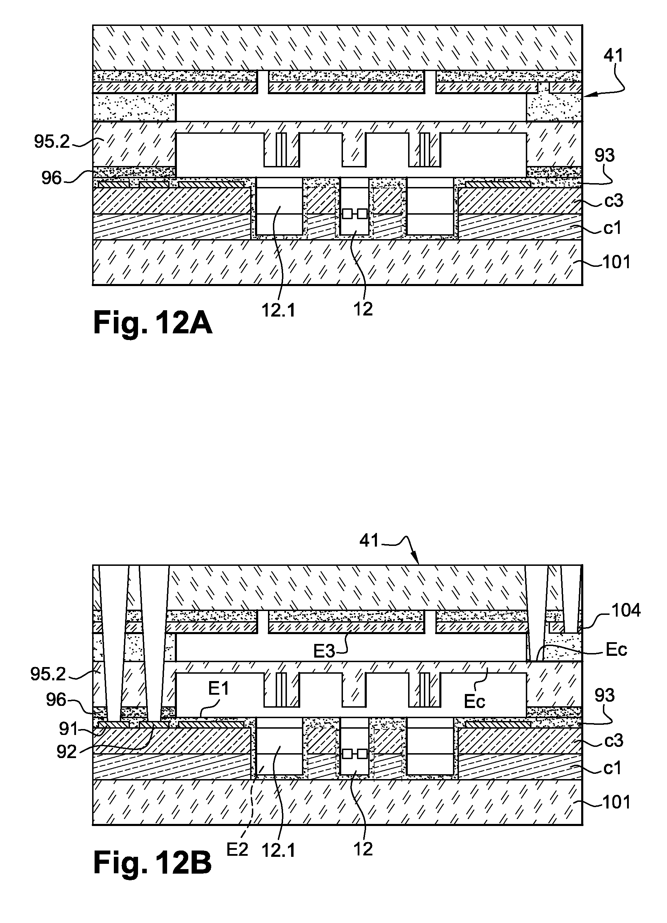

L'étape illustrée à la figure 12A est un assemblage du substrat façonné illustré à la figure 11D, ayant subi un retournement au-dessus de la structure illustrée à la figure 10B. L'électrode fixe E3 surmonte le bloc mobile et donc l'électrode mobile Ec. L'assemblage peut être un scellement de mêmes types que ceux cités lors de la description de la figure 10A.

Enfin une étape de gravure est entreprise au niveau des plots 91, 92 et au niveau de l'électrode Ec et du plot 104 pour effectuer les reprises de contact des diverses électrodes E1, E2, E3, Ec (figure 12B).

On va maintenant s'intéresser un exemple de procédé de fabrication d'un dispositif optique selon l'invention comparable à celui illustré aux figures 5 avec comme seconde référence mécanique des protubérances et comme première référence mécanique des rainures en V et une mise en relation essentiellement perpendiculaire au plan de la structure optique de guidage.

On part d'un premier substrat 101 par exemple en silicium. On le recouvre d'un matériau conducteur 106, par exemple du silicium dopé, de l'AlSi, un matériau métallique tel que de l'aluminium ou de l'or.

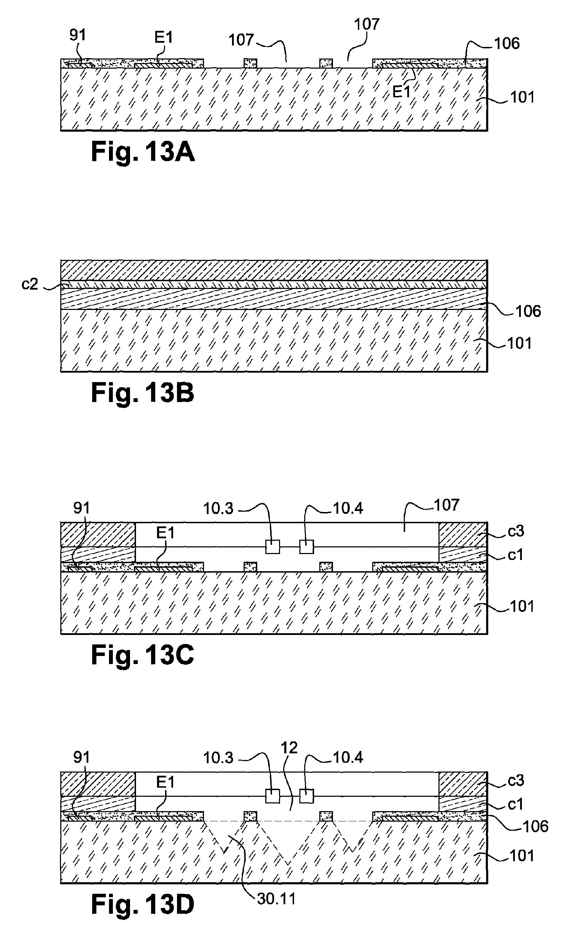

Par photolithographie et gravure, on va délimiter le contour des électrodes E1 fixes des moyens pour mettre en relation la seconde référence mécanique et la première référence mécanique. On prévoit classiquement au moins un plot 91 d'accès à ces électrodes E1. On recouvre le substrat 101 ainsi façonné d'une couche isolante 106 devant servir de masque de photolithographie pour la gravure des rainures et de la cavité devant accueillir l'élément optique mobile (figure 13A). Cette couche 106 est par exemple en oxyde de silicium et/ou en nitrure de silicium et est déposée par un procédé de dépôt chimique en phase vapeur assisté par plasma connu sous l'abréviation PECVD pour plasma enhanced chemical vapor deposition. Dans cette couche 106 sont gravées des ouvertures 107 correspondant au contour des rainures et de la cavité.

On va ensuite réaliser la structure optique de guidage de la même manière qu'à l'étape de la figure 8A. On dépose une première couche c1 qui va servir d'enrobage, on la recouvre d'une seconde couche c2 qui va servir de coeur aux voies optiques guidées. Cette seconde couche c2 est gravée pour délimiter le contour du coeur. La seconde couche c2 est recouverte d'une troisième couche c3 qui sert d'enrobage (figure 13B). Cette figure est une coupe selon l'axe EE' de la figure 5A.

Dans l'empilement formé des couches c1 à c3, on va dégager par gravure un espace 107 qui correspond à une partie de la cavité dans laquelle débouchent les voies optiques guidées de la structure optique de guidage ainsi qu'à un espace dans lequel vont se trouver les protubérances avant la mise en relation entre première et seconde références mécaniques (figure 13C). Sur cette figure 13C qui est une coupe selon l'axe FF' de la figure 5A, deux voies optiques guidées 10.3, 10.4 sont vues en coupe transversale. On grave ensuite le fond de la cavité 12 et les rainures en V 30.11 dans le premier substrat 101 (figure 13D).

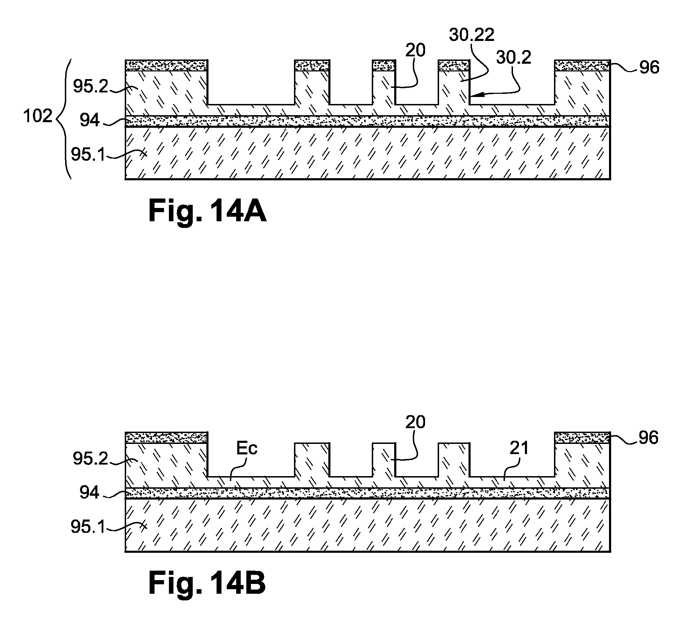

Dans un second substrat 102 conforme à celui décrit à la figure 9A, on délimite par gravure l'élément optique 20, les protubérances 30.22 de la seconde référence mécanique 30.2, le support flexible 21 et si nécessaire la liaison flexible (si elle n'est pas englobée dans le support flexible) (figure 14A). La gravure peut être par exemple une gravure sèche anisotrope à travers un masque d'oxyde 96 par exemple d'oxyde de silicium. La gravure s'arrête dans la couche supérieure 95.2 de matériau semi-conducteur.

On dégage ensuite le masque d'oxyde 96 sur les parties gravées amenées à se mouvoir (appelé par la suite bloc mobile): c'est à dire le support flexible 21, la seconde référence mécanique 30.2 et l'élément optique 20 (figure 14B). Cette gravure peut se faire par gravure sèche ou humide de l'oxyde après avoir protégé le reste de la couche d'oxyde par exemple par une couche de résine.

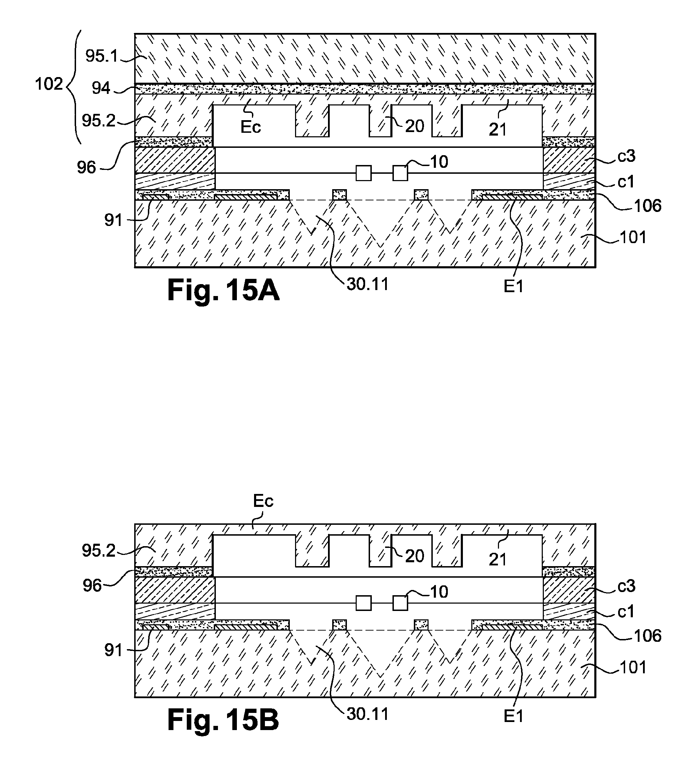

La figure 15A illustre l'assemblage entre le premier substrat 101 portant la structure optique de guidage 10 et le second substrat 102 retourné et portant le bloc mobile. Cet assemblage peut se faire comme décrit à la figure 10A.

La figure 15B illustre, à la manière de la figure 10B, la libération du bloc mobile.

On se réfère aux figures 11A à 11D pour expliquer la fabrication partielle des moyens de déplacement de l'élément optique à partir d'un troisième substrat 103.

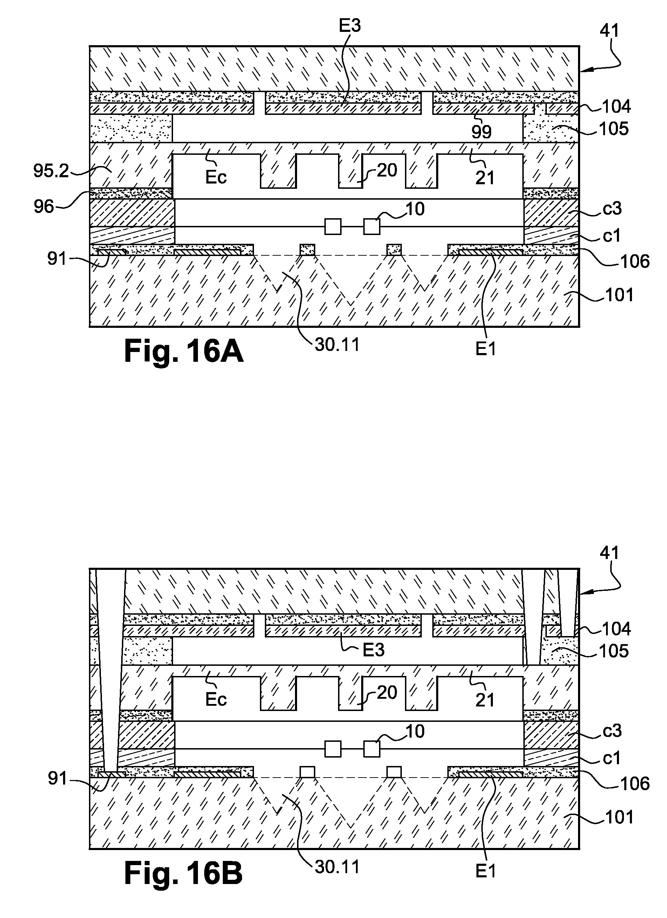

La figure 16A illustre l'assemblage du substrat façonné illustré à la figure 11D, ayant subi un retournement au-dessus de la structure illustrée à la figure 15B. L'électrode fixe E3 surmonte le bloc mobile. L'assemblage peut être un scellement de mêmes types que ceux cités lors de la description de la figure 10A.

La figure 16B illustre une étape de gravure au niveau des plots 91, 104 et de l'électrode Ec pour effectuer des reprises de contact des diverses électrodes E1, E3, Ec.

Bien que plusieurs modes de réalisation de la présente invention aient été représentés et décrits de façon détaillée, on comprendra que différents changements et modifications puissent être apportés notamment au niveau de la forme du dispositif de positionnement, de l'élément optique mobile et de la structure optique de guidage sans sortir du cadre de l'invention. On pourrait aussi envisager d'inverser les protubérances et les logements, les logements matérialiseraient la seconde référence mécanique et les protubérances la première référence mécanique.

### DOCUMENTS CITES

***[1]***
   "Bistable 2x2 and multistable 1x4 micromechanical fibre-optic switches on silicon", P. Kopka, M. Hoffmann, E. Voges, MOEMS 99, Mainz (D), August 30-September 1, 1999.
***[2]***
   "Low voltage, wavelengh and polarisation indépendant micro-opto-mechanical switch integrated on silicon", E. Ollier, P. Mottier, ECIO 97, Stockholm (Sweden), April 2 - 4,1997.
***[3]***
   "Optical-layer networking : opportunities for and progress in ligthwave micromachines", L. Y. Lin, E.L. Goldstein, OFC 2000, Baltimore (US), March 7-10, 2000.
***[4]***
   "4x4 fiber optic matrix switch based on MOEMS", C. Marxer, Y. Girardin, N. F. De Rooij, MOEMS 99, Mainz (D), August 30-September 1, 1999.
***[5]***
   "Free-space micromachined optical switches with submillisecond switching time for large-scale optical crossconnects", L. Y. Lin, E. L. Goldstein, R. W. Tkach, IEEE photonics Technology Letters, Vol. 10, N⁰ 4, April 1998.
***[6]***
   "Micro-opto-electro-mechanical switch for optical network" M. Mita, Ph. Helin, D. Miyauchi, H. Toshiyoshi, H. Fujita, LIMMS Activity Report, March 1998-March 1999.
***[7]***
   "Development of a multi-channel 2X2 switch" Y. Kato, T. Norimatsu, O. Imaki, T. Sasaki, K. Kondo, K. Mori, Optical MEMS Conference, 20-23 August 2002, Lugano, Switzerland.
***[8]***
   "An SOI optical microswitch integrated with silicon waveguides and touch-down micromirror actuators" Young-Hyun Jin et al, Optical MEMS 2000 Conference, 21-24 August, Kauai, Hawaï, USA.
***[9]***
   "Micromachined curling optical switch array for PLC based integrated programmable add/drop multiplexer" M. Katayama et al, OFC 2001 Conference, March 2001, Anaheim, CA USA.
***[10]***
   "4X4 matrix switch based on MEMS switches and integrated waveguides" L. Dellmann et al, Transducers 01 Conference, 10-14 June 2001, Munich, Germany.
***[11]***
   EP 0 961 150 A2.
***[12]***
   US 5 148 506.
***[13]***
   FR-2 817 050.
***[14]***
   "Global révolution for Nanovation" ECOC 2000 Exibition News, 2000.

## Revendications

1. Dispositif optique comportant une structure optique de guidage (10) d'au moins un faisceau optique (11), un élément optique mobile (20) destiné à interagir ou non avec le faisceau optique grâce à des moyens de déplacement (40) de l'élément optique, un support flexible (21) reliant l'élément optique à la structure optique de guidage, **caractérisé en ce qu'**il comporte un dispositif de positionnement (30) de l'élément optique par rapport à la structure optique de guidage comportant une première référence mécanique (30.1) liée à la structure optique de guidage et une seconde référence mécanique (30.2) liée à l'élément optique mobile, des moyens (30.3) pour mettre en relation la seconde référence mécanique et la première référence mécanique, cette mise en relation autorisant un mouvement de l'élément optique selon au moins un plan contenant au moins la première et la seconde références mécaniques (30.1, 30.2) ainsi que la structure optique de guidage (10).

2. Dispositif optique selon la revendication 1, **caractérisé en ce que** l'élément optique (20) est apte à se mouvoir en translation et/ou en rotation.

3. Dispositif optique selon l'une des revendications 1 ou 2, **caractérisé en ce que** les moyens (30.3) pour mettre en relation et les moyens de déplacement (40) sont distincts.

4. Dispositif optique selon l'une des revendications 1 à 3, **caractérisé en ce que** les moyens (30.3) pour mettre en relation sont passifs, la mise en relation intervenant lors de la fabrication du dispositif optique.

5. Dispositif optique selon l'une des revendications 1 à 3, **caractérisé en ce que** les moyens (30.3) pour mettre en relation sont actifs et sont activables avant et/ou pendant et/ou après le déplacement de l'élément optique mobile (20).

6. Dispositif optique selon la revendication 5, **caractérisé en ce que** les moyens (30.3) pour mettre en relation comportent au moins un couple d'électrodes (Ec, E1), dans le couple une (Ec) des électrodes étant mobile.

7. Dispositif optique selon la revendication 6, **caractérisé en ce que** les moyens (30.3) pour mettre en relation comportent plusieurs couples d'électrodes (Ec1, E1, Ec2, E2) les électrodes de couples différents s'étendant dans des plans sensiblement perpendiculaires.

8. Dispositif optique selon l'une des revendications 1 à 7, **caractérisé en ce que** la seconde référence mécanique (30.2) est liée d'une manière flexible à l'élément optique mobile (30.2) par une liaison flexible (30.4).

9. Dispositif optique selon la revendication 8, **caractérisé en ce que** la liaison flexible (30.4) a une épaisseur inférieure à celle d'une électrode mobile (Ec1) des moyens (30.3) pour mettre en relation.

10. Dispositif optique selon l'une des revendications 1 à 7, **caractérisé en ce que** le support flexible (21), la seconde référence mécanique (30.2) liée à l'élément optique mobile (20) forment un bloc mobile.

11. Dispositif optique selon la revendication 10, **caractérisé en ce que** le bloc mobile porte ou forme au moins une électrode mobile (Ec1) des moyens (30.3) pour mettre en relation et une électrode mobile (Ec3) des moyens de déplacement (40).

12. Dispositif optique selon l'une des revendications 1 à 11, **caractérisé en ce que** l'élément optique mobile (20) est apte à plonger dans ou à sortir d'une cavité (12) lors de son déplacement, la structure optique de guidage (10) débouchant dans la cavité (12).

13. Dispositif optique selon la revendication 12, **caractérisé en ce que** la cavité (12) contient un fluide d'adaptation d'indice.

14. Dispositif optique selon l'une des revendications 1 à 13, **caractérisé en ce que** les moyens de déplacement (40) comportent une électrode fixe (E3) solidaire d'un couvercle (41) de protection de l'élément optique mobile.

15. Dispositif optique selon l'une des revendications 1 à 14, **caractérisé en ce que** la première référence mécanique (30.1) et la seconde référence mécanique (30.2) sont choisies parmi une ou plusieurs surfaces, une ou plusieurs pièces (30.20) à arête ou à pointes ou une combinaison de ces éléments.

16. Dispositif optique selon l'une des revendications 1 à 15, **caractérisé en ce que** la première référence mécanique (30.1) et la seconde référence mécanique (30.2) sont choisies parmi une ou plusieurs protubérances (30.22), un logement (30.11) pour chaque protubérance ou une combinaison de ces éléments.

17. Dispositif selon la revendication 16, **caractérisé en ce que** le logement (30.11) est équipé de moyens de guidage (30.12) pour la protubérance (30.22).

18. Dispositif selon l'une des revendications 16 ou 17, **caractérisé en ce que** le logement (30.11) est une rainure en V.

19. Dispositif optique selon la revendication 18, **caractérisé en ce que** les moyens de guidage (30.12) sont les parois de la rainure en V.

20. Dispositif optique selon la revendication 17, **caractérisé en ce que** les moyens de guidage (30.12) sont des languettes souples.

21. Dispositif optique selon l'une des revendications 1 à 20, **caractérisé en ce que** la structure optique de guidage (10) comporte n voies optiques guidées (10.10) d'un côté de l'élément optique (20) mobile et m voies optiques (10.20) d'un autre côté de l'élément optique mobile, n et m étant des entiers, au moins l'un d'entre eux étant supérieur ou égal à un.

22. Dispositif optique selon la revendication 21, **caractérisé en ce qu'**une voie optique guidée (10.10, 10.20) est un guide optique ou une fibre optique.

23. Dispositif optique selon l'une des revendications 1 à 22, **caractérisé en ce que** l'élément optique (20) mobile est une lame optique semi-réfléchissante, un miroir, un obturateur, un prisme, une lentille.

24. Brasseur optique **caractérisé en ce qu'**il comporte une pluralité de dispositifs optiques selon l'une des revendications 1 à 23, disposés en lignes et colonnes dans lesquels la structure optique de guidage (10) de chaque dispositif comporte deux voies optiques guidées (10.1, 10.2) disposées selon un angle non nul d'un même côté de l'élément optique mobile (20) et deux voies optiques guidées (10.3, 10.4) disposées selon un angle non nul d'un autre côté de l'élément optique mobile (20) et lesdits dispositifs optiques sont reliés optiquement en ligne et/ou en colonne par leurs voies optiques respectives.

25. Procédé de réalisation d'un dispositif optique selon les revendications 1 à 23, **caractérisé en ce qu'**il comporte les étapes suivantes :
sur un premier substrat (101), réalisation de la structure optique de guidage (10),
gravure d'une cavité (12) dans laquelle débouche la structure optique de guidage et réalisation de la première référence mécanique (30.1),
réalisation d'électrodes (E1, E2) pour les moyens de mise en relation,
à partir d'un second substrat (102), délimitation d'un bloc mobile incluant la seconde référence mécanique (30.2) liée à l'élément optique (20) et le support flexible (21),
assemblage du premier substrat (101) et du second substrat (102) retourné,
libération du bloc mobile en conservant une liaison mécanique avec le premier substrat (101),
à partir d'un troisième substrat (103), réalisation d'une électrode (E3) des moyens de déplacement (40),
assemblage au-dessus du second substrat d'un couvercle (41) au fond duquel se trouve l'électrode (E3) des moyens de déplacement (40).

26. Procédé selon la revendication 25, **caractérisé en ce que** les électrodes sont protégées par un matériau diélectrique (93, 96).

27. Procédé selon l'une des revendications 25 ou 26, **caractérisé en ce que** le second substrat (102) et le troisième substrat (103) sont des substrats SOI.

28. Procédé selon l'une des revendications 25 à 27, **caractérisé en ce que** l'étape de libération du bloc mobile inclut un amincissement.

29. Procédé selon l'une des revendications 25 à 28, **caractérisé en ce que** les électrodes (E1, E2) sont déposées sur le premier substrat (101) avant la réalisation de la structure de guidage (20) et la gravure de la cavité (12) dans laquelle débouche la structure optique de guidage (10).

30. Procédé selon la revendication 29, **caractérisé en ce que** l'étape de gravure est suivie d'une étape de gravure de rainures en V dans le premier substrat (101), ces rainures matérialisant la première référence mécanique (30.1).

31. Procédé selon l'une des revendications 25 à 28, **caractérisé en ce que** les électrodes (E1, E2) sont réalisées après l'étape de gravure.
